# EUROPEAN PATENT SPECIFICATION

(11) **EP 4 356 149 B1**
(45) Date of publication and mention of the grant of the patent: **22.07.2026**
(21) Application number: 22741128.7
(22) Date of filing: 06.06.2022
(51) Int. Cl.: G01R 1/067, G01R 1/073, G01R 31/28

(54) **PROBE HEAD WITH REPLACEABLE PROBE BOARD**
TASTKOPF MIT AUSWECHSELBARER SONDENPLATINE
TÊTE DE SONDE À CARTE DE SONDE REMPLAÇABLE

(30) Priority: 16.06.2021 US 202163202548 P
(43) Date of publication of application: 24.04.2024
(60) Divisional application: 26175985.6
(73) Proprietor: Xallent Inc., Albany, New York 12203 (US)
(72) Inventor: AMPONSAH, Kwame, Latham, New York 12110 (US); OZDOGAN, Mehmet, Ithaca, New York 14850 (US); KUMAR, Pardeep, Ithaca, New York 14850 (US); D'SOUZA, Clive A., Ithaca, New York 14850 (US)
(74) Representative: Potter Clarkson
(86) International application number: PCT/US2022/072768
(87) International publication number: WO 2022/266579

(56) References cited:
- JP-A- H02 187 666
- US-A- 4 827 211
- US-A1- 2005 140 386
- US-A1- 2019 369 142

## Description

### Field of the Invention

The present disclosure is directed generally to probe heads for testing semiconductor integrated circuits and thin film materials.

### Backaround

While conducting research, scientists pay for silicon real estate on a multi-project wafer (MPW). Decreasing the size of test pads on a wafer reduces die costs and enables a single IC manufacturing run to support more chip designs. For example, in a conventional design, more than 60% of a test chip may be used by test pads. US 2019/369142 discloses a hybrid probe head assembly for testing a wafer device under test. The hybrid probe head assembly includes a housing, at least a portion of a lead frame assembly disposed in the housing, the lead frame assembly including a at least one cantilever portion, the at least one cantilever portion including an undeflected position and a deflected position, where the lead frame assembly hinges between the undeflected position and the deflected position at a lead frame pivot point, and the at least one cantilever portion extends to a wafer contact. In the undeflected position, the at least one cantilever portion is disposed at a 8-12 degree angle, and in the deflected position, the at least one cantilever portion is disposed at a 2-4 degree angle. One or more spring probes are disposed within the housing and have a wafer contact tip.
US 4827211 discloses a wafer probe for accessing bonding pads on a planar device. The wafer probe includes contact pads mounted on one edge of the under side of a dielectric substrate board and arranged to align with the bonding pads to be accessed. Coplanar ground and signal conductors deposited on the under side of the substrate board form constant impedance transmission lines for connecting test equipment to the contact pads. A ground contact is mounted on the upper side of the substrate near the end on which the contact pads are mounted, the ground contact being connected by a conductive path to the ground conductors on the under side of the substrate. When two such wafer probes simultaneously access bonding pads on the same planar device, the ground conductors of the two probes are interconnected by a conductive sheet of foil extending between the ground contacts on the upper sides of the substrates of both wafer probes.

### Summary of the Invention

The present disclosure is directed generally towards a probe head for testing integrated circuits (ICs) and thin film materials. The probe head consists of a structure with a slot for accepting a probe board that houses a probe chip. The probe head is realized by using traditional machining (metal, ceramic, etc.), 3D printing, or molding to build the head.

In some examples, the present invention relates to a probe head that utilizes a portfolio of probe chips for testing integrated circuits (IC) and thin film materials. The probe chips have dramatically reduced width, pitch, and tip surface area, enabling IC designs with smaller test pad pitch. Dramatically reducing pad sizes allows for a greater number of test features per die, which in tum improves die yields, device performance, and reliability. A test chip prepared for the present invention may have a chip size reduction of over 25%. The reduction in size improves test chip technology development with regards to 1 nm, 3 nm, and 5 nm nodes, commonly referred to as "advanced nodes" in the semiconductor industry.

Generally, in one aspect, a probe head is provided according to independent claim 1. Further aspects are defined in the dependent claims.

These and other aspects of the invention will be apparent from the embodiments described below.

### Brief Description of the Drawings

The present invention will be more fully understood and appreciated by reading the following Detailed Description in conjunction with the accompanying drawings, in which:
FIG. 1 is a perspective view of a probe card according to the present disclosure.
FIG. 2A is a perspective view of a probe card according to the present disclosure.
FIG. 2B is an expanded view of the probe card shown in FIG. 2A according to the present disclosure.
FIG. 3A is a backside schematic representation of a probe head according to the present disclosure.
FIG. 3B is a frontside schematic representation of a probe head according to the present disclosure.
FIG. 3C is a backside schematic representation of a probe head with inserted pogo pins according to the present disclosure.
FIG. 3D is a schematic representation of a pogo pin according to the present disclosure.
FIG. 3E is a schematic representation of a probe head with inserted pogo pins in both the front lid and backside according to the present disclosure.
FIG. 4A is a schematic representation of the frontside of a daughterboard according to the present disclosure.
FIG. 4B is a schematic representation of the backside of a daughterboard according to the present disclosure.
FIG. 4C is a schematic representation of the frontside of a daughterboard according to the present disclosure.
FIG. 4D is a schematic representation of the backside of a daughterboard according to the present disclosure.
FIG. 5A is a schematic representation of a daughterboard integrated with a probe head according to the present disclosure.
FIG. 5B is a schematic representation of a daughterboard integrated with a probe head according to the present disclosure.
FIG. 5C is a schematic representation of a daughterboard integrated with a probe head according to the present disclosure.
FIG. 6A is a schematic representation of the frontside of a motherboard according to the present disclosure.
FIG. 6B is a schematic representation of the backside of a motherboard according to the present disclosure.
FIG. 6C is a schematic representation of the frontside of a motherboard according to the present disclosure.
FIG. 6D is a schematic representation of the backside of a motherboard according to the present disclosure.
FIG. 7A is a schematic representation of the motherboard integrated with the daughterboard wherein the probe head is connected to the daughterboard according to the present disclosure.
FIG. 7B is a schematic representation of a metal pin or pogo pin that connects the daughterboard to the motherboard according to the present disclosure.
FIG. 8A is a schematic representation of the motherboard integrated with the daughterboard wherein a probe board is inserted into the probe head according to the present disclosure.
FIG. 8B is a schematic representation of the motherboard integrated with the daughterboard wherein a probe board is inserted into the probe head according to the present disclosure.
FIG. 8C is a schematic representation of the motherboard integrated with the daughterboard wherein a probe board is inserted into the probe head according to the present disclosure.
FIG. 9 is a schematic representation of a daughterboard cover according to the present disclosure.
FIG. 10A is a schematic representation of a probe card according to the present disclosure.
FIG. 10B is an expanded view of a probe card according to the present disclosure.
FIG. 10C is a schematic representation of a probe card according to the present disclosure.
FIG. 11A is a schematic representation of a stiffener according to the present disclosure.
FIG. 11B is a schematic representation of a stiffener according to the present disclosure.
FIG. 11C is a schematic representation of a stiffener according to the present disclosure.
FIG. 11D is a schematic representation of a stiffener with a handle according to the present disclosure.
FIG. 11E is a schematic representation of a probe card mounted on top of a wafer prober according to the present disclosure.
FIG. 12A is a schematic representation of a probe chip according to the present disclosure.
FIG. 12B is a schematic representation of a probe chip according to the present disclosure.
FIG. 13A is a frontside schematic representation of a probe board according to the present disclosure.
FIG. 13B is a backside schematic representation of a probe board according to the present disclosure.
FIG. 13C is a schematic representation of a probe board according to the present disclosure.
FIG. 13D is a frontside schematic representation of a probe board according to the present disclosure.
FIG. 13E is a backside schematic representation of a probe board according to the present disclosure.
FIG. 13F is a schematic representation of a probe board according to the present disclosure.
FIG. 14A is a schematic representation of a probe chip that is wire-bonded to a probe board according to the present disclosure.
FIG. 14B is a schematic representation of a probe chip that is wire-bonded to a probe board according to the present disclosure.
FIG. 15A is a schematic representation of a probe card with an integrated camera according to the present disclosure.
FIG. 15B is a schematic representation of a probe card with an integrated camera according to the present disclosure.
FIG. 16A is a frontside schematic representation of a motherboard according to the present disclosure.
FIG. 16B is a backside schematic representation of a motherboard according to the present disclosure.
FIG. 16C is a frontside schematic representation of a motherboard according to the present disclosure.
FIG. 16D is a backside schematic representation of a motherboard according to the present disclosure.
FIG. 17A is a schematic representation of a motherboard integrated with a probe head according to the present disclosure.
FIG. 17B is a schematic representation of a motherboard integrated with a probe head and a probe board inserted into the probe head according to the present disclosure.
FIG. 17C is a schematic representation of a motherboard integrated with a camera according to the present disclosure.
FIG. 17D is a schematic representation of a motherboard integrated with a camera and daughterboard cover according to the present disclosure.
FIG. 17E is a schematic representation of a motherboard integrated with a probe head according to the present disclosure.
FIG. 17F is a schematic representation of a motherboard integrated with a probe head and a probe board inserted into the probe head according to the present disclosure.
FIG. 17G is a schematic representation of a probe card according to the present disclosure.
FIG. 18A is a schematic representation of a probe head according to the present disclosure.
FIG. 18B is a schematic representation of a probe head according to the present disclosure.
FIG. 18C is a schematic representation of a probe head connected to a cable and cable connector according to the present disclosure.
FIG. 18D is a schematic representation of a probe head showing the wirings to the pogo pins according to the present disclosure.
FIG. 18E is a schematic representation of a probe head connected with a back cover according to the present disclosure.
FIG. 19A is a frontside schematic representation of a probe board according to the present disclosure.
FIG. 19B is a backside schematic representation of a probe board according to the present disclosure.
FIG. 19C is a schematic representation of a probe board wire-bonded to a probe chip according to the present disclosure.
FIG. 20A is a schematic representation of a probe head that is connected to a manipulator according to the present disclosure.
FIG. 20B is an expanded view schematic representation of a probe head that is connected to a manipulator according to the present disclosure.
FIG. 20C is a schematic representation of a probe head according to the present disclosure.
FIG. 20D is a schematic representation of a probe head according to the present disclosure.
FIG. 21A is a schematic representation of a probe head that is connected to a manipulator according to the present disclosure.
FIG. 21B is an expanded view schematic representation of a probe head that is connected to a manipulator according to the present disclosure.
FIG. 22 is a schematic representation of a probe head that is connected to a microscope assembly according to the present disclosure.
FIG. 23 is a schematic representation of a probe head that is connected to a manipulator and the manipulator mounted onto a microscope assembly according to the present disclosure.
FIG. 24 is a schematic representation of a microscope assembly according to the present disclosure.
FIG. 25 is a schematic representation of a microscope assembly mounted on top of a wafer prober according to the present disclosure.
FIG. 26 is a schematic representation of a probe card and microscope setup mounted on top of a wafer prober according to the present disclosure.
FIG. 27 is an unclaimed example method of monitoring a condition of at least a probe tip, according to the present disclosure.

### Detailed Description of Embodiments

The present disclosure describes various embodiments of a probe head and probe card for testing semiconductor integrated circuits (ICs) and thin film materials. The probe head enables detailed analysis of electrical, mechanical, and chemical response of ICs and thin film materials.

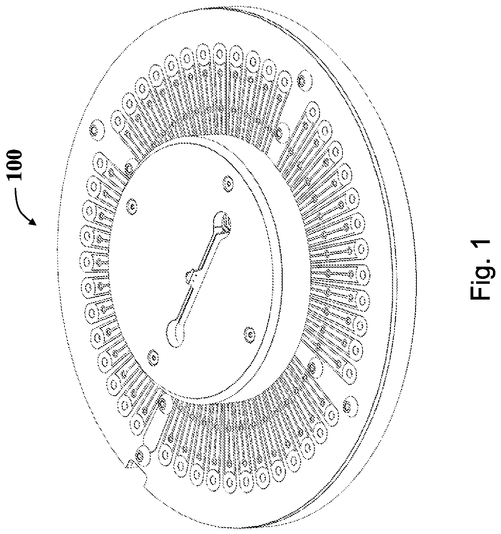

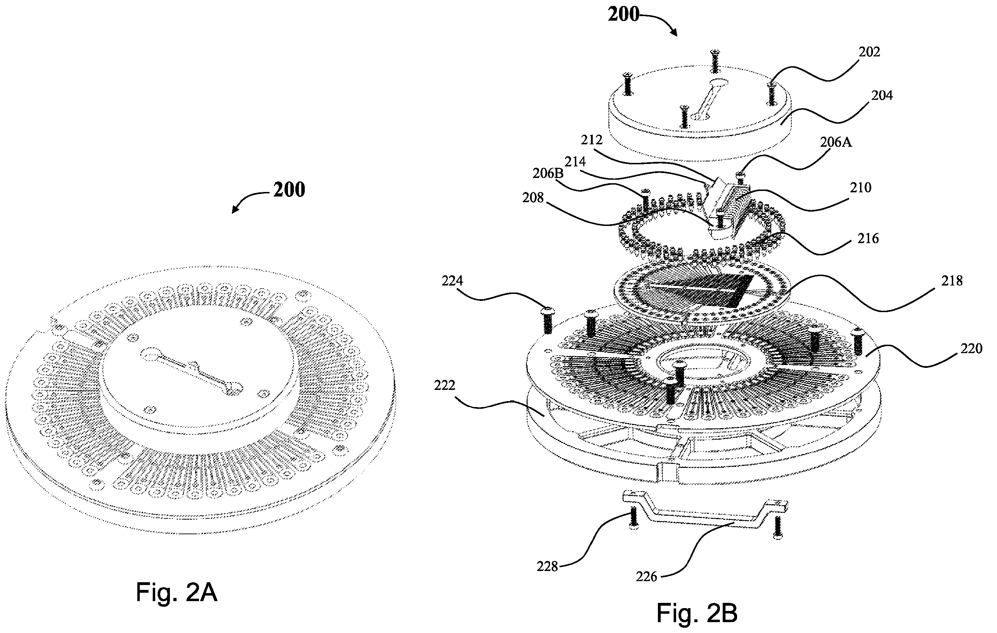

FIG. 1 illustrates a perspective view of a probe card 100 according to the present disclosure. FIG. 2A illustrates a proposed probe card 200.

FIG. 2B illustrates an expanded view of the probe card 200 displaying its various components. The probe card 200 includes a motherboard 220 and a daughterboard 218 that are connected to each other with pins 216 and screws 206A and 206B. A probe head 208 is connected to the daughterboard 218 with screws 206A, and wires 210 from the probe head 208 are soldered to the daughterboard 218. A probe board 212 is inserted into the probe head 208. The probe board 212 houses a probe chip 214. The daughterboard 218 is enclosed in a daughterboard cover 204 that could be secured to the stiffener 222 with the screws 202. Screws 224 connect the motherboard 220 to the stiffener 222. To safely move the probe card around, a handle 226 could be connected to the backside of the stiffener 222 with screws 228.

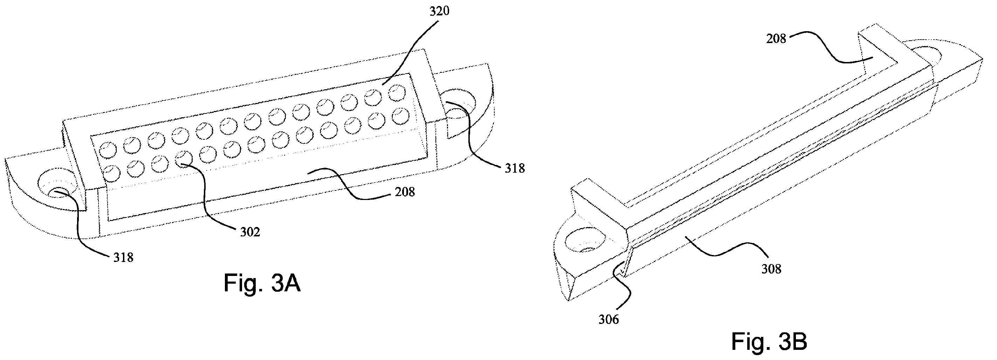

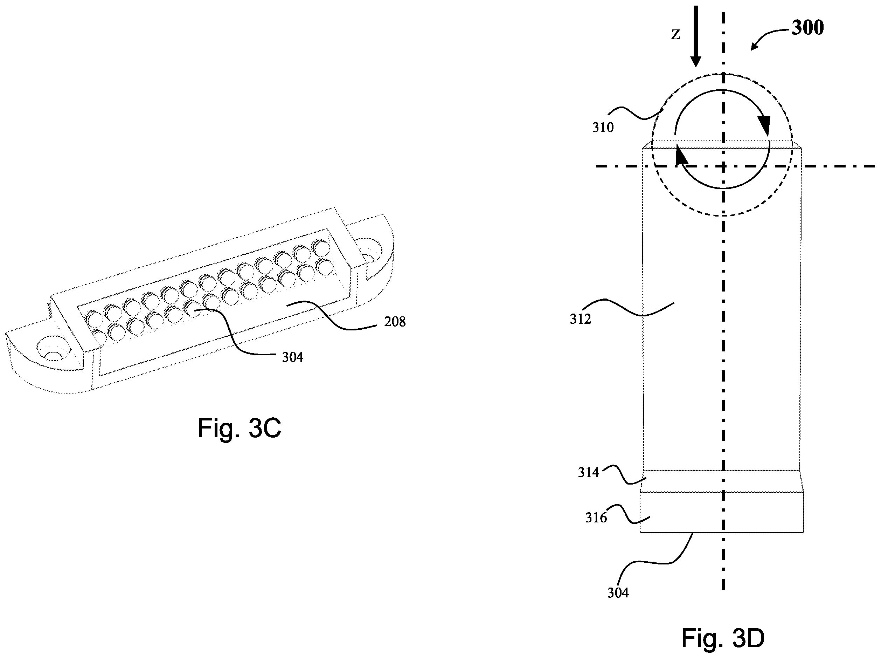

FIG. 3A, in accordance with an example embodiment, illustrates the backside 320 of the probe head 208 and holes 302. Spring-loaded pogo pins 300 (see FIG. 3D) are inserted into holes 302. Holes 318 accept screws that allow for the probe head 208 to be connected to the daughterboard 218 or motherboard 220 (see FIG. 2B).

FIG. 3B, in accordance with an example embodiment, illustrates that the probe head 208 includes a front lid 308 and a slot 306. A probe board 212 (see FIG. 2B) would be inserted into slot 306. In another example embodiment, a set of holes 302 (see FIG. 3A) could be made in the front lid 308 and configured for pogo pins 300 (see FIG. 3D) to be inserted into them.

FIG. 3C, in accordance with an example embodiment, illustrates that the conductive pogo pins 300 (see FIG. 3D) are inserted into the holes 302 (see FIG. 3A) of the probe head 208. The base 304 of the pogo pins 300 could be soldered to a wire.

FIG. 3D, in accordance with the invention, illustrates that the pogo pin 300 has a conductive rotating ball 310 at its apex. The ball 310 is mounted on a spring (not shown) which allows the ball to move up and down, extended and retracted in reference to the shank 312 of the pogo pin 300. The ball 310 is capable of rotating 360 degrees in all directions to allow for sliding when in contact with the probe board 212 (see FIG. 2B). The pogo pin 300 could be designed to press-fit into a hole 302 (see FIG. 3A) of the probe head 208. To secure the pogo pin 300 into the hole 302, the diameter of its base portion 314 could be designed to be larger than the diameter of the hole 302. A wire could be soldered to base 304 to provide an electrical signal through the shank 312 to the ball 310. In another embodiment, the pogo pin 300 could be designed to have a pin (not shown) that replaces the ball 310. In such an instance, the pin would not offer rotating capability, but could be moved up and down, extended, and retracted in reference to the shank 312 of the pogo pin 300. The pin will be mounted on a spring (not shown).

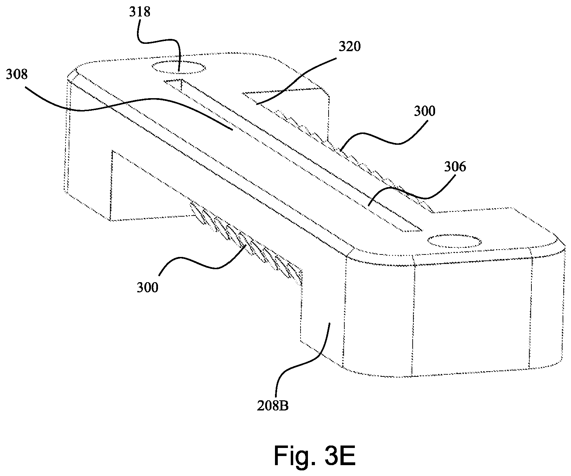

FIG. 3E, in accordance with an example embodiment, illustrates a probe head 208B, a variation of the previously presented probe heads 208. Pogo pins 300 are inserted in both the front cover 308 and backside 320 of the probe head 208B. Holes 318 accept screws that allow for the probe head 208B to be connected to the daughterboard 218 or motherboard 220 (see FIG. 2B). A probe board 212 (see FIG. 2B) could be inserted in slot 306.

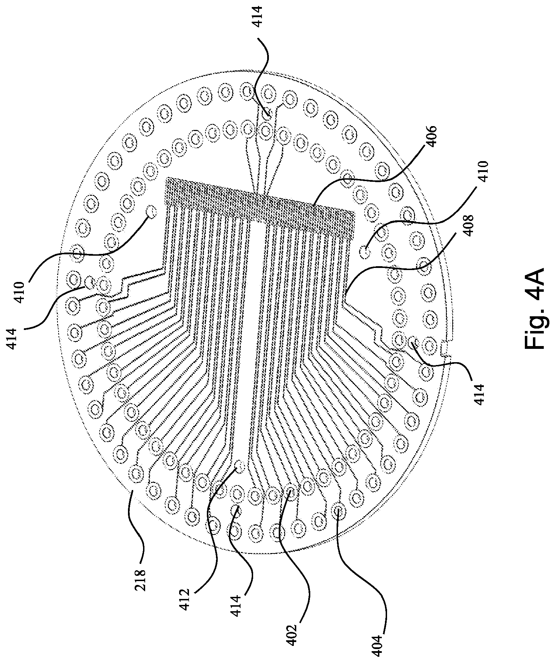

FIG. 4A, in accordance with an example embodiment, illustrates a daughterboard 218. The frontside of the daughterboard 218 is shown. The daughterboard 218 could be a printed circuit board (PCB). The daughterboard 218 could be made of FR4, ceramic, plastic, mica, Roger-board, etc. The daughterboard 218 includes metal plated guard vias 402 and force or sense vias 404, solder pads 406, and metal traces 408. In testing environments, current or voltage may be applied at force vias, while current or voltage may be measured at sense vias. Vias 404 of FIG. 4A may be configured as either force vias or sense vias. A probe head 208 (see FIG. 3A) is connected to the daughterboard 218 with screws 206A and 206B (see FIG. 2B). Screws 206A and 206B go through the screw holes 410 and 412 respectively to connect the daughterboard 218 to the motherboard 220 (see FIG. 2B). The probe head 208 is connected to the daughterboard 218 via screw holes 410. To secure the daughterboard cover 204 (see FIG. 2B) to the daughterboard 218, screws 202 (see FIG. 2B) are inserted into the daughterboard cover 204 (see FIG. 2B) and into screw holes 414 on the daughterboard 218.

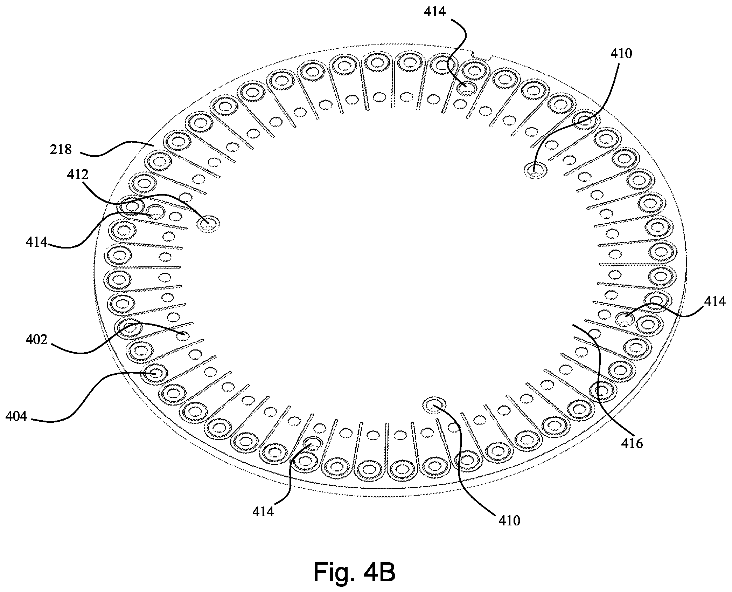

FIG. 4B, in accordance with an example embodiment, illustrates the backside of the daughterboard 218. A ground plane 416 is implemented to minimize capacitive and resistive parasitics in the metal traces 408 (see FIG. 4A) on the frontside of the daughterboard 218. The sense/force vias 404, and the holes (or vias) 410, 412, and 414 are all electrically isolated from the ground plane 416.

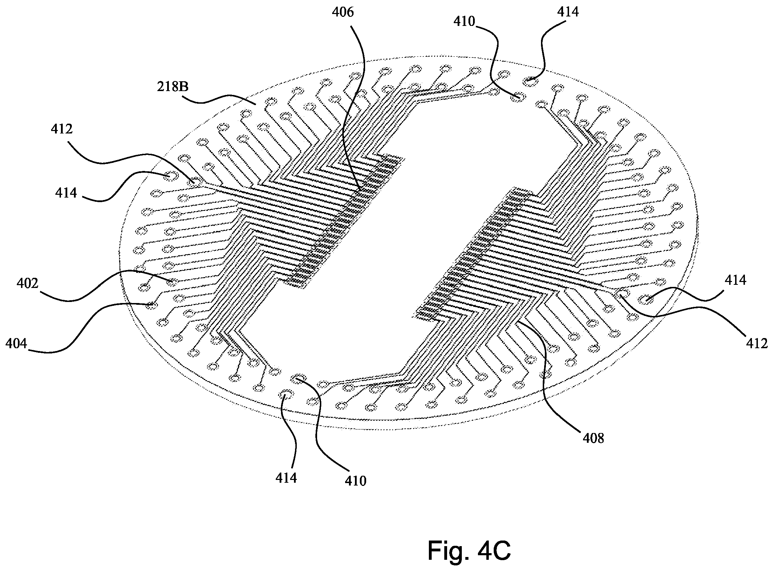

FIG. 4C, in accordance with an example embodiment, illustrates the frontside of a daughterboard 218B, a variation of the daughterboard 218 shown in FIG. 4A. The daughterboard 218B could be a PCB. The daughterboard 218B could be made of FR4, ceramic, plastic, mica, Roger-board, etc. The daughterboard 218B includes of metal plated guard vias 402 and force or sense vias 404, solder pads 406, metal traces 408. The probe head 208B (see FIG. 3E) is connected to the daughterboard 218B with screws 206A and 206B (see FIG. 2B). Screws 206A and 206B go through the screw holes 410 and 412 respectively to connect the daughterboard 218B to the motherboard 220B (see FIG. 2B). The probe head 208B is connected to the daughterboard 218B via screw holes 410. To secure the daughterboard cover 204 (see FIG. 2B) to the daughterboard 218B, screws 202 (see FIG. 2B) are inserted into the daughterboard cover 204 and into screw holes 414 on the daughterboard 218B.

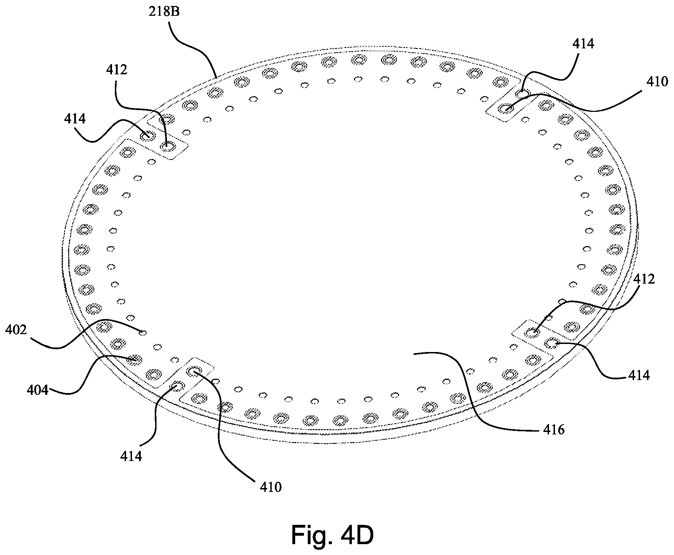

FIG. 4D, in accordance with an example embodiment, illustrates the backside of daughterboard 218B. A ground plane 416 is implemented to minimize capacitive and resistive parasitics in the metal traces 408 (see FIG. 4C) on the frontside of the daughterboard 218B. The sense/force vias 404, vias 410, 412, and 414 are all electrically isolated from the ground plane 416.

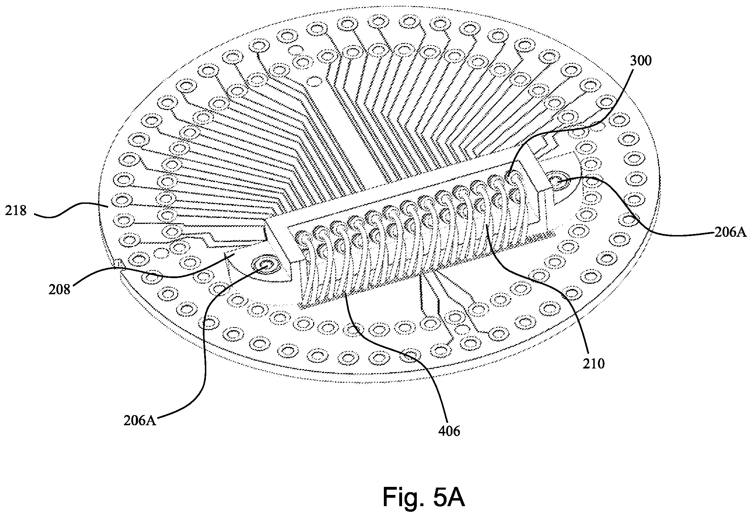

FIG. 5A, in accordance with an example embodiment, illustrates daughterboard 218 integrated with a probe head 208. One end of a wire 210 is connected to the pogo pin 300, and the other end of the wire 210 is connected to solder pad 406 on the daughterboard 218. Screws 206A are used to secure the probe head 208 to the daughterboard 218.

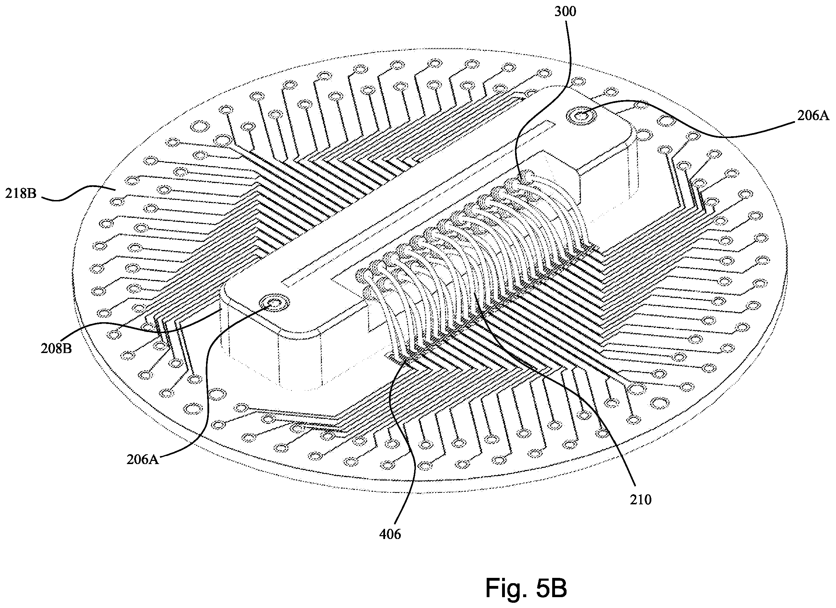

FIG. 5B, in accordance with an example embodiment, illustrates the daughterboard 218B integrated with a probe head 208B. One end of a wire 210 is connected to the pogo pin 300, and the other end of the wire 210 is connected to solder pad 406 on the daughterboard 218B. Screws 206A are used to secure the probe head 208B to the daughterboard 218B.

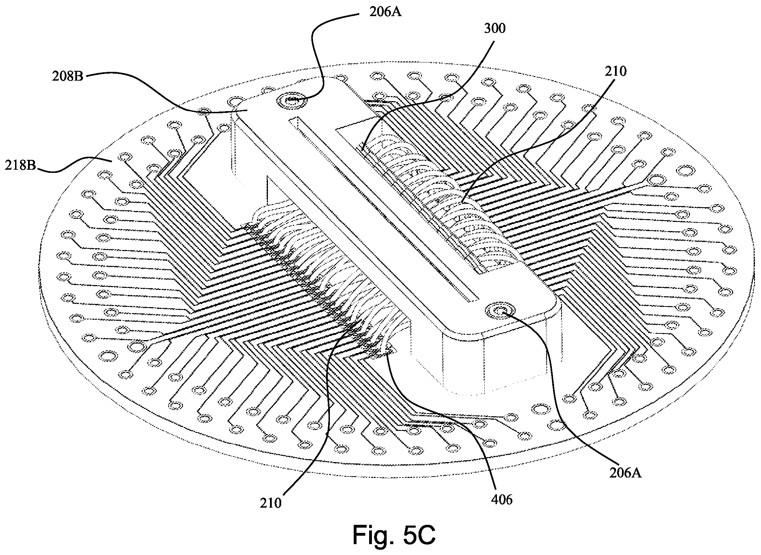

FIG. 5C, in accordance with an example embodiment, illustrates the daughterboard 218B integrated with a probe head 208B. One end of a wire 210 is connected to the pogo pin 300, and the other end of the wire 210 is connected to solder pad 406 on the daughterboard 218B. Screws 206A are used to secure the probe head 208B to the daughterboard 218B.

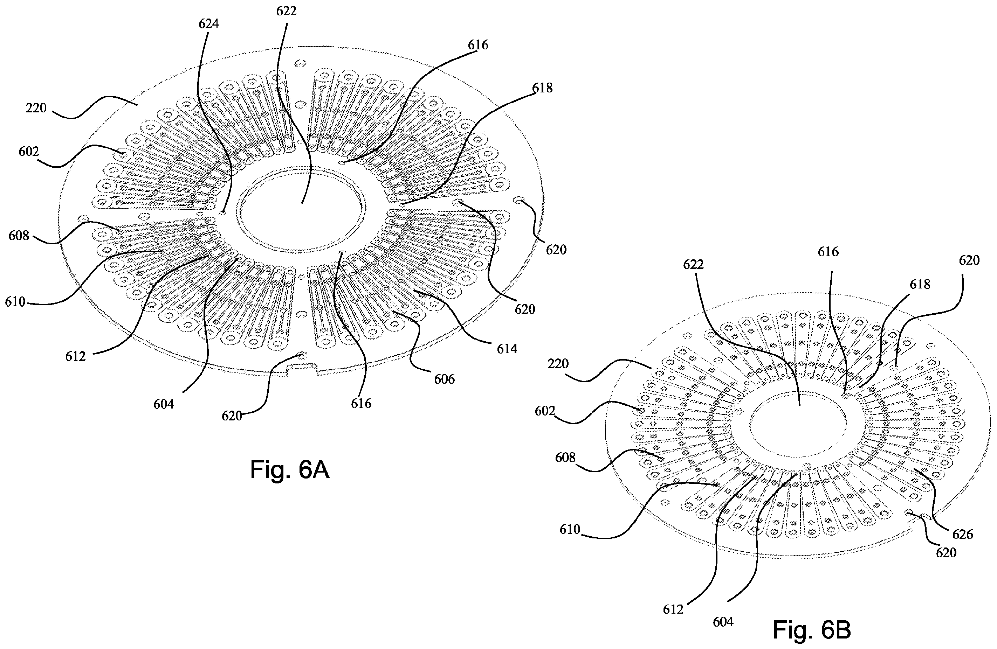

FIG. 6A, in accordance with an example embodiment, illustrates the frontside of the motherboard 220 designed with a guard-force-sense (G-F-S) configuration. The motherboard 220 could be a PCB. The motherboard 220 could be made of FR4, ceramic, plastic, mica, Roger-board, etc. Metal plated vias (or pads) 602, 604 are connected to guard traces 606. Metal plated vias (or pads) 608 are configured to receive a force signal from automatic test equipment (ATE). Metal plated vias (or pads) 610 are configured to receive a sense signal from the ATE. A metal trace 614 connects the force via/pad 608 to the sense via/pad 610 and via/pad 612. Screws 206A (see FIG. 2B) connect the probe head 208 (see FIG. 2B) and daughterboard 218 (see FIG. 2B) to the motherboard 220 via hole 616. The probe head 208, motherboard 220, and daughterboard 218 can also be mounted to stiffener 222 (see FIG. 2B) via threaded holes. Screws 206B (see FIG. 2B) connect the daughterboard 218 to the motherboard 220 via hole 624. Screws 202 (see FIG. 2B) connect the daughterboard cover 204 (see FIG. 2B) to the motherboard 220 via holes 618. And finally, screws 224 (see FIG. 2B) connects the motherboard 220 to the stiffener 222 via holes 620. Hole 622 is optional and allows for a microscope to view one or more probe tips through an opening in the daughterboard 218.

FIG. 6B, in accordance with an example embodiment, illustrates the backside of the motherboard 220. Metal plated vias or pads 602, 604 connect to the guard plane 626. Metal plated via (or pad) 608 receives the force signal from an ATE. Metal plated via (or pad) 610 are configured to receive the sense signal from an ATE. The force vias/pads 608, sense vias/pads 610, and via/pad 612 are electrically isolated from the guard trace 626.

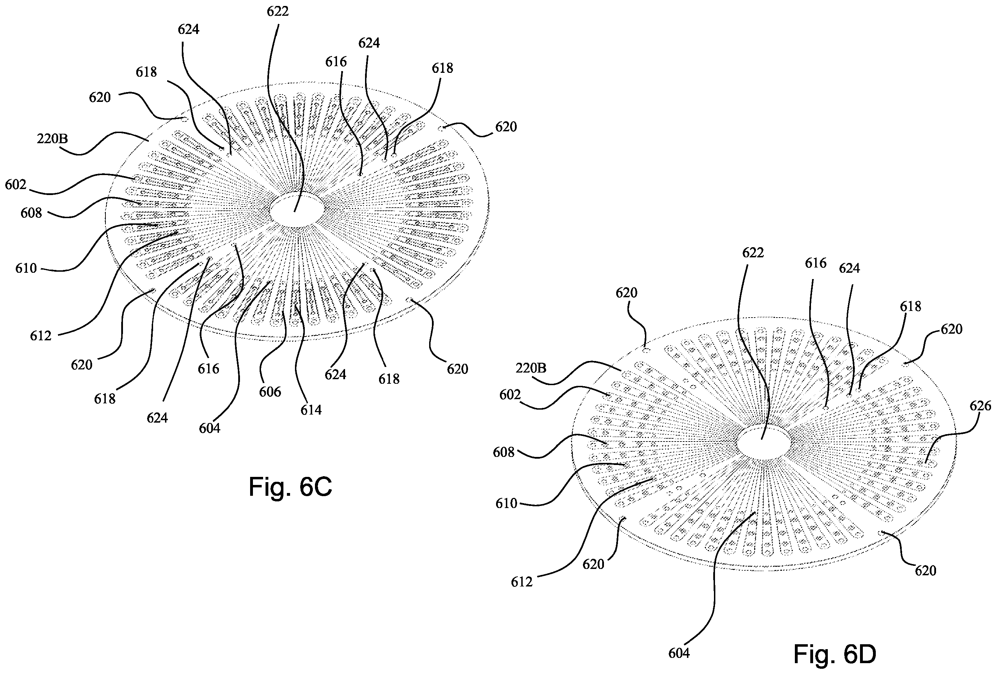

FIG. 6C, in accordance with a further example embodiment, illustrates that the frontside of a motherboard 220B, a variation of the motherboard 220 of FIG. 6A, designed with a G-F-S configuration. The motherboard 220B could be a PCB. The motherboard 220B could be made of FR4, ceramic, plastic, mica, Roger-board, etc. Metal plated vias (or pads) 602, 604 connect to the guard traces 606. Metal plated via or pad 608 is configured to receive a force signal from ATE. Metal plated via (or pad) 610 is configured to receive a sense signal from the ATE. A metal trace 614 connects the force via/pad 608 to the sense via/pad 610 and via/pad 612. Screws 206A (see FIG. 2B) connect the probe head 208B (see FIG. 3E) and daughterboard 218B (see FIG. 4C) to the motherboard 220B via hole 616. The probe head 208B, motherboard 220B, and daughterboard 218B can also be mounted to stiffener 222 (see FIG. 2B) via threaded holes. Screws 206B (see FIG. 2B) connect the daughterboard 218B to the motherboard 220B via hole 624. Screws 202 (see FIG. 2B) connect the daughterboard cover 204 (see FIG. 2B) to the motherboard 220B via holes 618. And finally, screws 224 (see FIG. 2B) connects the motherboard 220B to the stiffener 222 (see FIG. 2B) via holes 620. Hole 622 is optional and allows for a microscope to view one or more probe tips through an opening in the daughterboard 218.

FIG. 6D, in accordance with an example embodiment, illustrates the backside of the motherboard 220B shown in FIG. 6C. Metal plated vias (or pads) 602, 604 connect to the guard plane 626. Metal plated via (or pad) 608 is configured to receive the force signal from ATE. Metal plated via (or pad) 610 is configured to receive the sense signal from ATE. The force vias/pads 608, sense vias/pads 610, and vias/pads 612 are electrically isolated from the guard trace 626.

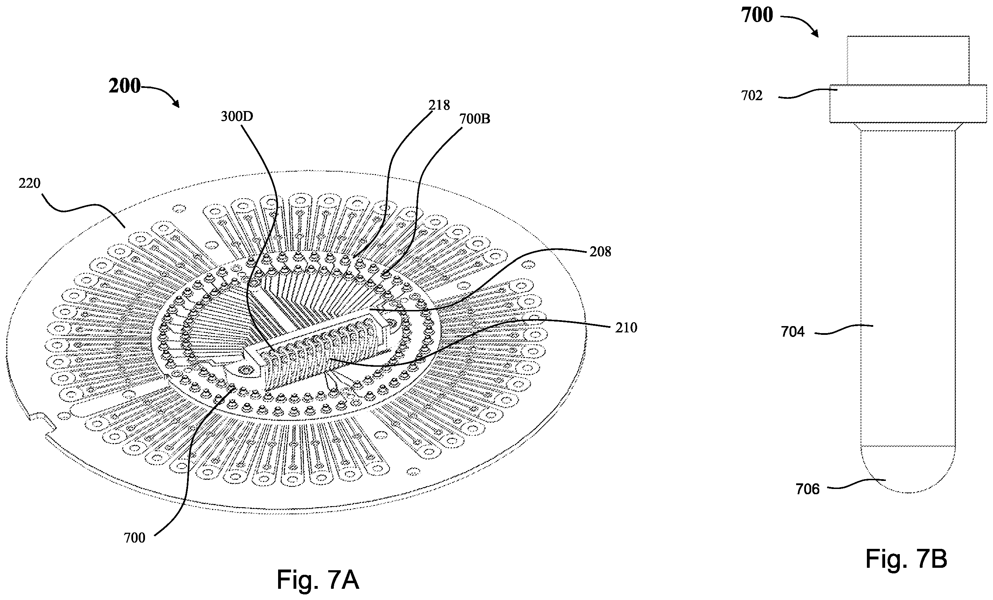

FIG. 7A, in accordance with an example embodiment, illustrates a probe card 200 where the probe head 208 is connected to the daughterboard 218 and then the daughterboard 218 is connected to the motherboard 220 via pins 700. Pins 700 electrically connect the metal plated vias 402, 404 (see FIG. 4A) on the daughterboard 218 to the metal plated vias 604, 612 (see FIG. 6A) on the motherboard 220. The conductive pins 700 may be pogo pins or standard metal pins.

FIG. 7B, in accordance with an example embodiment, illustrates a metal pin 700 that connects the daughterboard 218 (see FIG. 7A) to the motherboard 220 (see FIG. 7A). The metal pin 700 is comprised of a cap 702, a shank 704, and a tip 706. The tip 706 is configured to contact metal plated pads on the motherboard 220. If the motherboard 220 is designed with vias 604, 612 (see FIG. 6A), then the shank 704 could press-fit into the vias 604, 612.

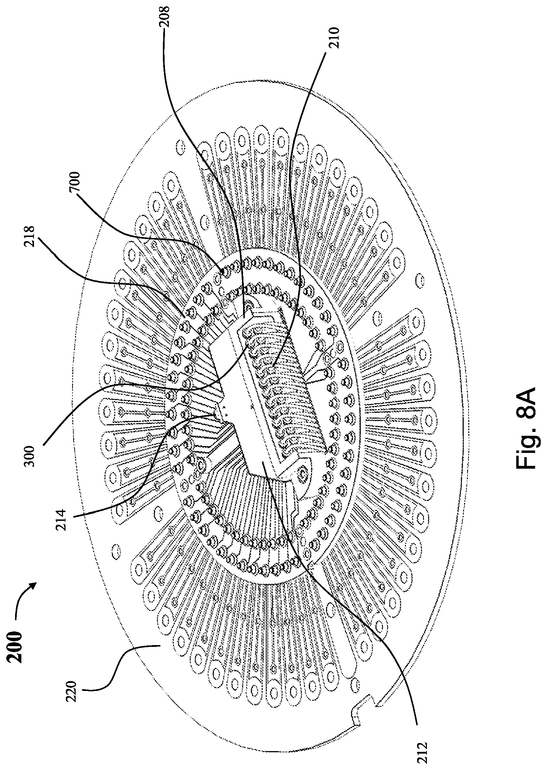

FIG. 8A, in accordance with an example embodiment, illustrates an example of a probe card 200 where the probe head 208 is connected to the daughterboard 218 and then the daughterboard 218 is connected to the motherboard 220. Pins 700 electrically connect the metal plated vias 402, 404 (see FIG. 4A) on the daughterboard 218 to the metal plated vias 604, 612 (see FIG. 6A) on the motherboard 220. A probe board 212 that houses a probe chip 214 is inserted into the probe head 208.

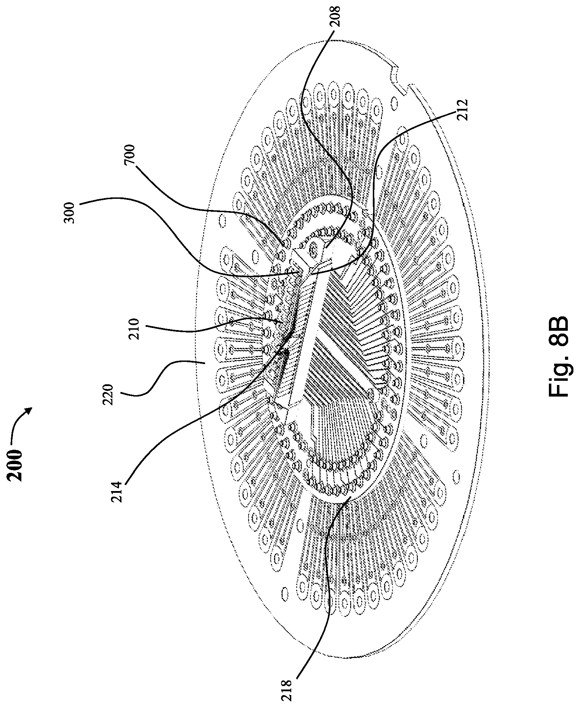

FIG. 8B, in accordance with an example embodiment, illustrates another example of a probe card 200 where the probe head 208 is connected to the daughterboard 218 and then the daughterboard 218 is connected to the motherboard 220. Pins 700 electrically connect the metal plated vias 402, 404 (see FIG. 4A) on the daughterboard 218 to the metal plated vias 604, 612 (see FIG. 6A) on the motherboard 220. A probe board 212 that houses a probe chip 214 is inserted into the probe head 208.

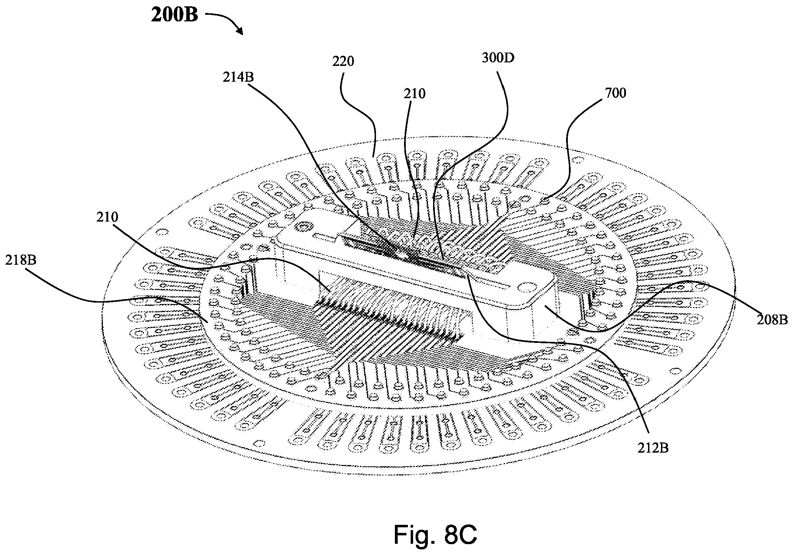

FIG. 8C, in accordance with an example embodiment, illustrates another example of a probe card 200B where the probe head 208B is connected to the daughterboard 218B and then the daughterboard 218B is connected to the motherboard 220B. Pins 700 electrically connect the metal plated vias 402, 404 (see FIG. 4A) on the daughterboard 218B to the metal plated vias 604, 612 (see FIG. 6A) on the motherboard 220. A probe board 212B that houses a probe chip 214B, a variation of the probe chip 214 of FIG. 8A, is inserted into the probe head 208B.

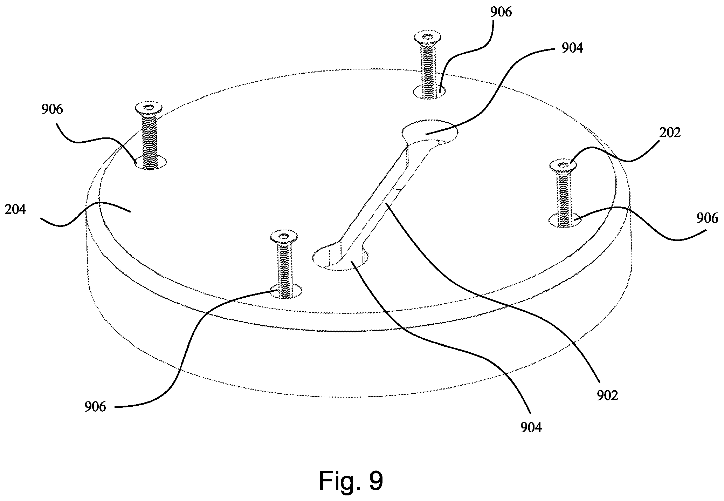

FIG. 9, in accordance with an example embodiment, illustrates daughterboard cover 204. The daughterboard cover 204 has a slot 902 for inserting a probe board 212 (see FIG. 2B). Openings 904 in the daughterboard cover 204 allows a person to insert a finger into the cover during mounting and dismounting of a probe board 212 (see FIG. 2B) into slot 306 (see FIG. 3B) of the probe head 208 (see FIG. 3B). The opening 904 also allows the use of a tweezer to grab the probe board 212 to mount or dismount into slot 306. Screws 202 help to connect the daughterboard cover 204 to the motherboard 220 (see FIG. 2B) via hole 906.

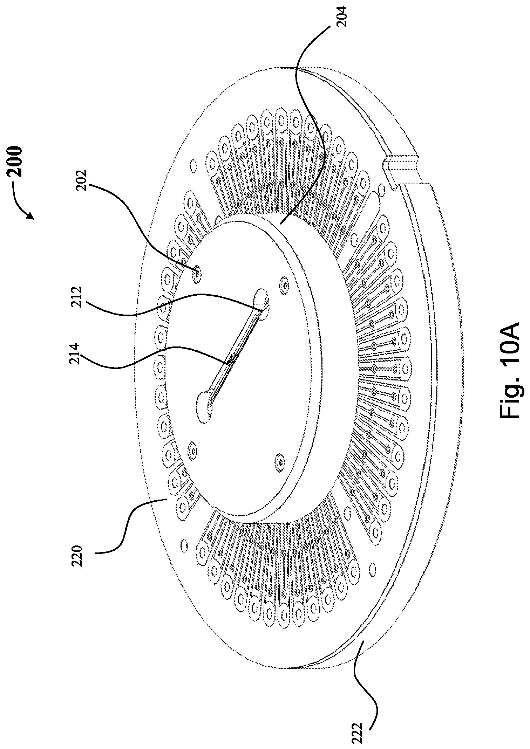

FIG. 10A, in accordance with an example embodiment, illustrates an example probe card 200 that is integrated with a daughterboard cover 204 and a stiffener 222. A probe board 212 that houses a probe chip 214 is inserted into the probe card 200. The daughterboard 218 (not shown) is inside the daughterboard cover 204. The probe board 212 could be replaced either manually or automatically. Fingers or tweezers could be manually used to replace the probe board 212. In regard to automatic replacement, a positioner with an integrated arm that has a mechanical clamp could be used. In this example, the clamp may grip the sides of the probe board 212.

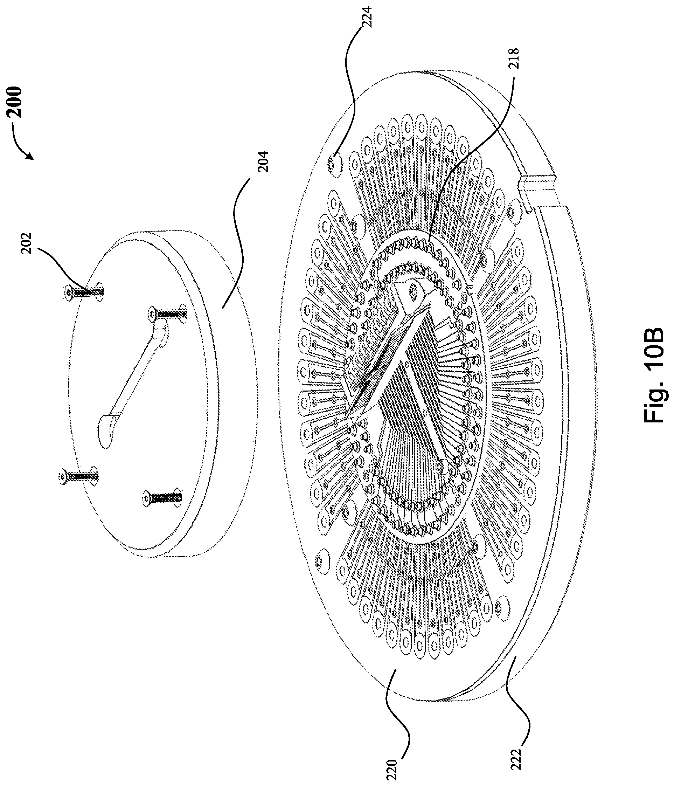

FIG. 10B, in accordance with an example embodiment, illustrates an expanded view of a probe card 200 of FIG. 10A showing its various components. Screws 224 are used to secure the motherboard 220 to the stiffener 222.

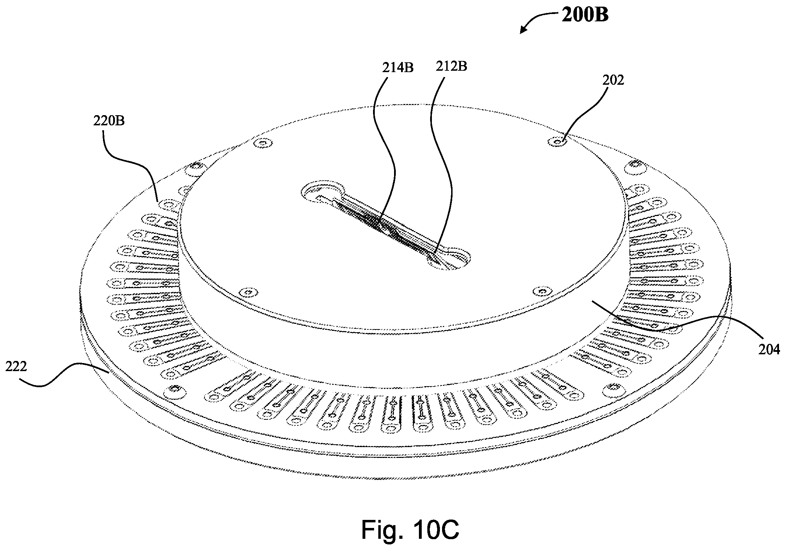

FIG. 10C, in accordance with an example embodiment, illustrates a probe card 200B (a variation of the probe cards of FIGS. 10A and 10B) that is integrated with a daughterboard cover 204 and a stiffener 222. A probe board 212B that houses a probe chip 214B is inserted into the probe card 200B. The daughterboard 218B (not shown) is inside the daughterboard cover 204.

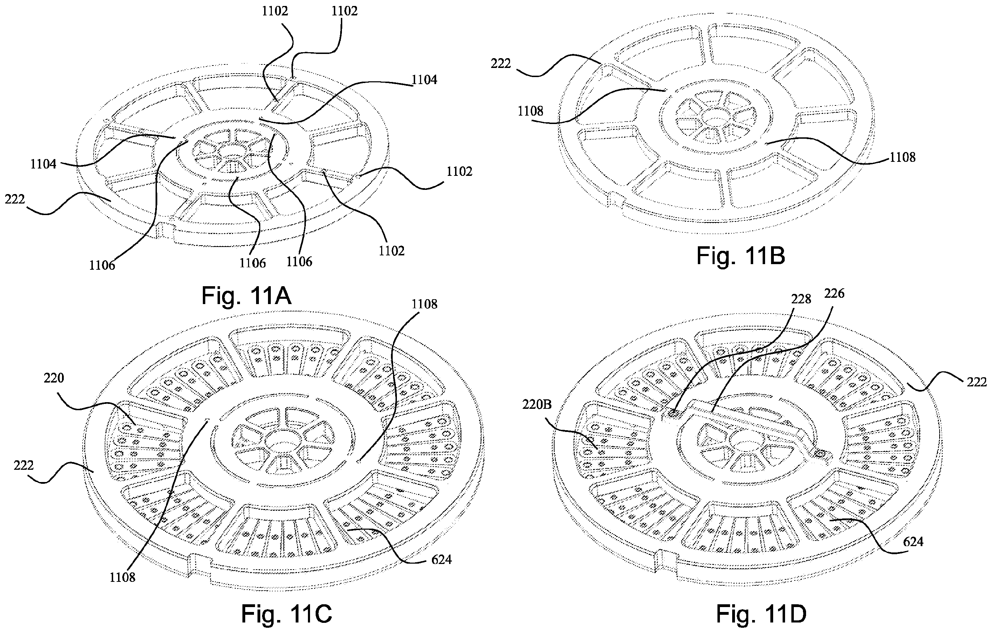

FIG. 11A, in accordance with an example embodiment, illustrates the frontside of a stiffener 222. Any of the previously described motherboards 220, 220B could be connected to the stiffener 222 by inserting screws 224 (see FIG. 2B) into holes 1102. Any of the previously described daughterboards 218, 218B could be connected to the stiffener 222 via holes 1106. The daughterboard cover 204 (see FIG. 9) could be connected to the stiffener 222 via holes 1104. In another example embodiment, the daughterboard 218, 218B is connected to the motherboard 220, 220B, and the motherboard 220, 220B is the component that is connected to the stiffener 222.

FIG. 11B, in accordance with an example embodiment, illustrates the backside of the stiffener 222 showing the holes 1108 for connecting a handle 226 (see FIG. 2B) to the stiffener 222.

FIG. 11C, in accordance with an example embodiment, illustrates the backside of a stiffener 222 with the motherboard 220, 220B connected to it. Screw holes 1108 for a handle 226 (see FIG. 2B) are also shown.

FIG. 11D, in accordance with an example embodiment, illustrates the backside of a stiffener 222 with the motherboard 220, 220B connected to it. A handle 226 (see FIG. 2B) could be connected to the stiffener 222 with screws 228.

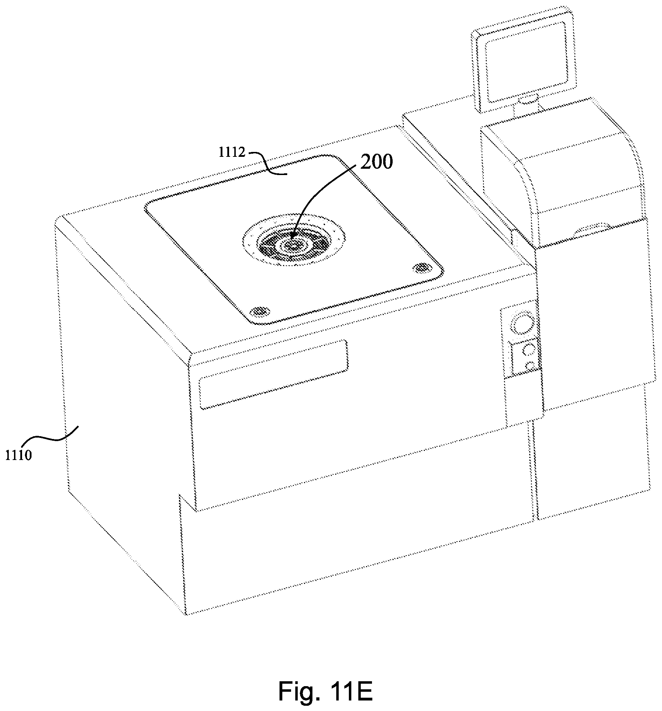

FIG. 11E, in accordance with an example embodiment, illustrates that probe card 200 (having the stiffener configuration shown in FIG. 11C) is mounted on top of a wafer prober 1110. Clamps (not shown) in the top cover 1112 of the wafer prober 1110 mechanically secure the probe card 200. Inside the wafer prober is a positioner with at least one degree of freedom. Typically, the positioner could comprise of XYZ stages, rotational stages, and tilt stages. The wafer or sample under test is placed on the positioner and software scripts are used to instruct the movement of the positioner.

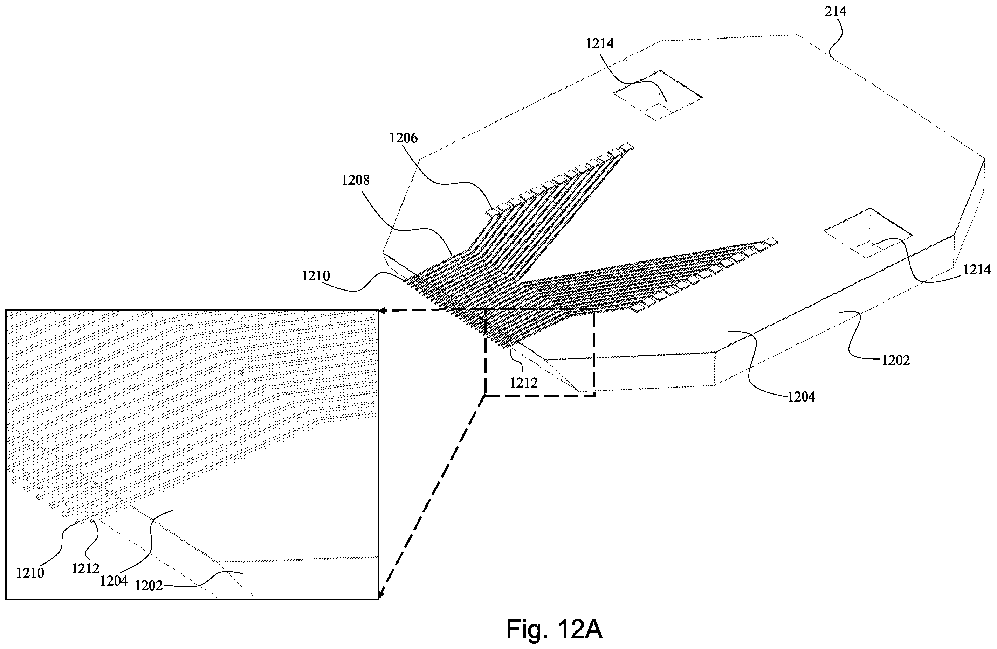

FIG. 12A, in accordance with an example embodiment, illustrates a probe chip 214. The probes are manufactured on a substrate 1202 which has an insulator layer 1204. Metal electrodes are formed on the top surface of the insulator layer 1204. A single probe is comprised of a conductive pad 1206, conductive wire trace 1208, and conductive probe tip 1210. In another embodiment, the probe tip rests on a support layer 1212. The support layer 1212 compensates for any stress gradient that might exist in the conductive probe tip and it ensures that the probe tip is parallel in reference to the top surface of the insulator layer 1204. Alignment openings 1214 are etched into the substrate 1202. The substrate 1202 could be silicon, silicon-germanium, Pyrex, glass, ceramic, or plastic. The insulator layer 1204 could be silicon-nitride, silicon-dioxide, or undoped polysilicon. The support layer 1212 could be silicon, polysilicon, silicon-nitride, silicon-dioxide, metal, or metal alloy. The conductive layers 1206, 1208, and 1210 could be metal or metal alloys. Example of metals are platinum, nickel, tungsten, beryllium copper, palladium, and their alloys. The probe chip 214 could also be manufactured from a printed circuit board where the substrate could be FR4, plastic, Roger-board, ceramic, etc. The metal pads 1206, metal traces 1208, and probe tips 1210 could be copper or other metals or metal alloys.

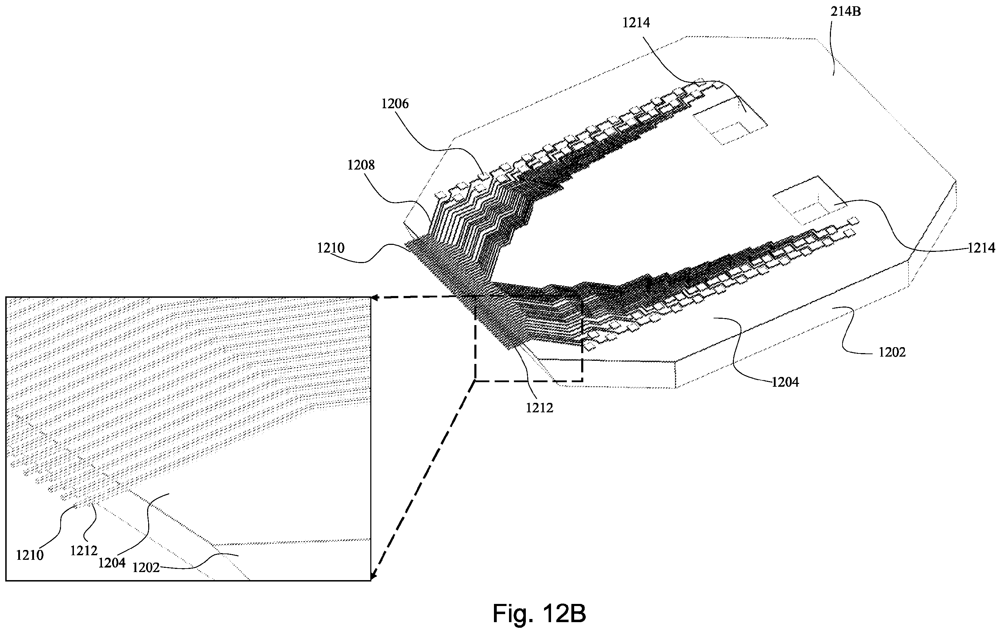

FIG. 12B, in accordance with an example embodiment, illustrates a variation of the probe chip 1200 of FIG 12A. The probes are manufactured on a substrate 1202 which has an insulator layer 1204. Metal electrodes are formed on the top surface of the insulator layer 1204. A single probe is comprised of a conductive pad 1206, conductive wire trace 1208, and conductive probe tip 1210. In another embodiment, the probe tip rests on a support layer 1212. The support layer 1212 compensates for any stress gradient that might exist in the conductive probe tip and it ensures that the probe tip is parallel in reference to the top surface of the insulator layer 1204. Alignment openings 1214 are etched into the substrate 1202. The substrate 1202 could be silicon, silicon-germanium, Pyrex, glass, ceramic, or plastic. The insulator layer 1204 could be silicon-nitride, silicon-dioxide, or undoped polysilicon. The support layer 1212 could be silicon, polysilicon, silicon-nitride, silicon-dioxide, metal, or metal alloy. The conductive layers 1206, 1208, and 1210 could be metal or metal alloys. Example of metals are platinum, nickel, tungsten, beryllium copper, palladium, and their alloys. The probe chip 214B could also be manufactured from a printed circuit board where the substrate could be FR4, plastic, Roger-board, ceramic, etc. The metal pads 1206, metal traces 1208, and probe tips 1210 could be copper or other metals or metal alloys.

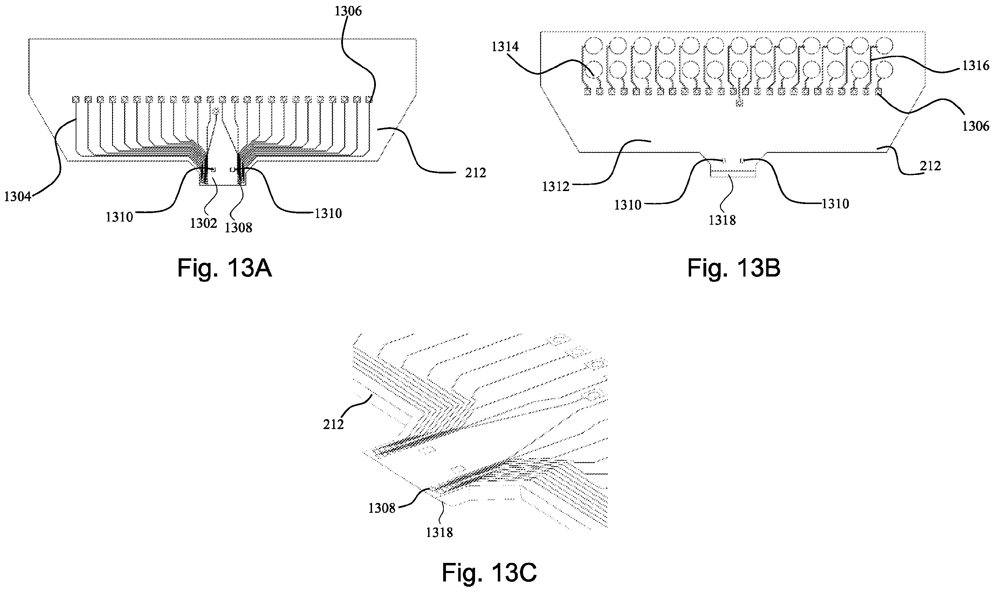

FIG. 13A, in accordance with an example embodiment, illustrates the frontside of a probe board 212. The probe board 212 could be a PCB. The probe board could be made from FR4, Roger board, ceramic, silicon, plastic. It could have a ground pad 1302 where the probe chip 214 shown in FIG. 12A will be seated. The probe board 212 has metal traces 1304 with metal plated vias 1306 at one end and metal pads 1308 on the other end. The vias 1306, the metal traces 1304, and pads 1308 are electrically isolated from the ground pad 1302. The probe board 212 also has alignment features 1310 which align to the holes 1214 on the probe chip 214 of FIG. 12A. The alignment feature 1310 could be a pillar or cut-out hole.

FIG. 13B, in accordance with an example embodiment, illustrates the backside of the probe board 212 of FIG. 13A. The probe board 212 has a backside ground plane 1312. Further, metal pads or vias 1314 are located at the backside of the probe board 212. When the probe board 212 is inserted into a probe head 208 (see FIG. 3A), the pogo pin balls 310 (see FIG. 3D) contact the pads 1314. The edge 1318 of the probe board 212 is angled. The metal pads 1314, metal traces 1316, and metal plated vias 1306 are electrically isolated from the ground plane 1312.

FIG. 13C, in accordance with an example embodiment, illustrates the probe board 212 of FIGS. 13A and 13B. The edge 1318 of the probe board 212 is tapered off at an angle.

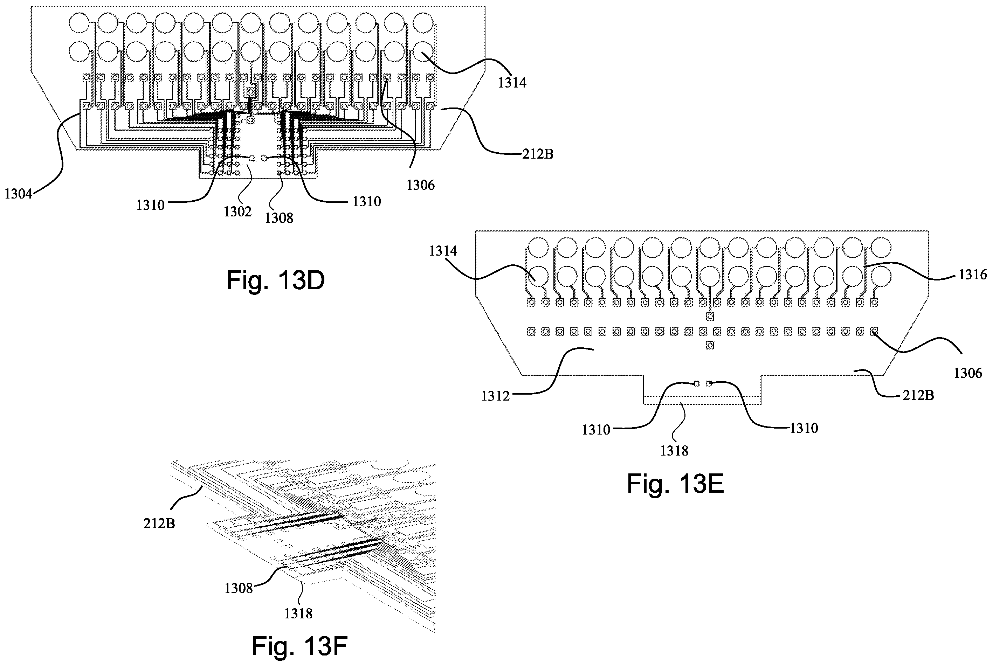

FIG. 13D, in accordance with an example embodiment, illustrates the frontside of a further example of a probe board 212B. The probe board 212B could be a PCB. The probe board could be made from FR4, Roger board, ceramic, silicon, plastic. It could have a ground pad 1302 where the probe chip 214B shown in FIG. 12B will be seated. The probe board 212B has metal traces 1304 with metal plated vias 1306 at one end and metal pads 1308 on the other end. The vias 1306, the metal traces 1304, and pads 1308 are electrically isolated from the ground pad 1302. The probe board 212B also has alignment features 1310 which align to the holes 1214 on the probe chip 214B of FIG. 12B. The alignment feature 1310 could be a pillar or cut-out hole.

FIG. 13E, in accordance with an example embodiment, illustrates the backside of a probe board 212B of FIG. 13D. The probe board 212B has a backside ground plane 1312. Further, metal pads or vias 1314 are located at the backside of the probe board 212B. When the probe board 212B is inserted into a probe head 208B (see FIG. 3E), the pogo pin balls 310 contact the pads 1314. The edge 1318 of the probe board 212B is angled. The metal pads 1314, metal traces 1316, and metal plated vias 1306 are electrically isolated from the ground plane 1312.

FIG. 13F, in accordance with an example embodiment, illustrates a probe board 212B. The edge 1318 of the probe board 212B is tapered off at an angle.

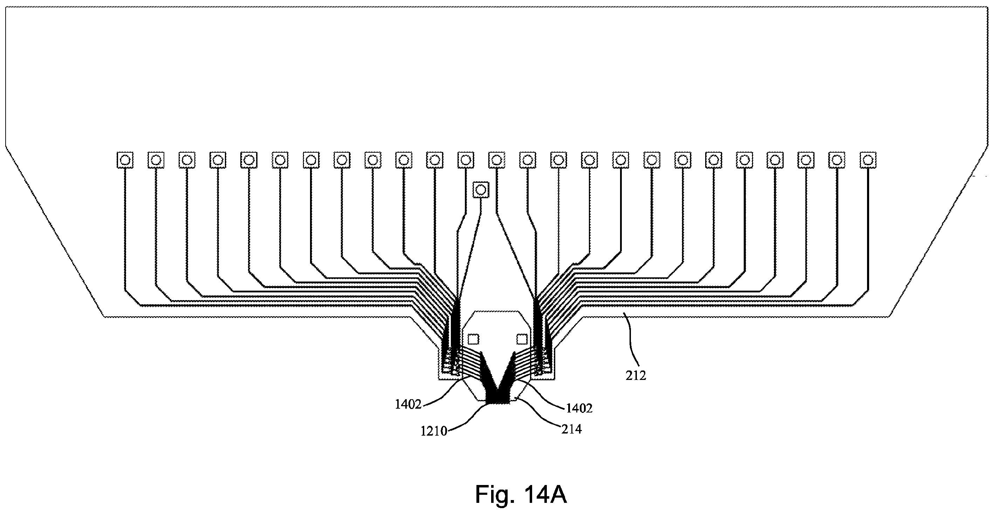

FIG. 14A, in accordance with an example embodiment, illustrates a probe chip 214 integrated with a probe board 212. Wire bonds 1402 connect pads 1206 (see FIG. 12A) on the probe chip 214 to pads 1308 (see FIG. 13A) on the probe board 212 (see FIG. 13A). In another embodiment, the probe board 212 and probe chip 214 could be monolithically integrated on a single substrate. The single substrate could be silicon, silicon-germanium, PCB, Pyrex, glass, silica, ceramic, etc.

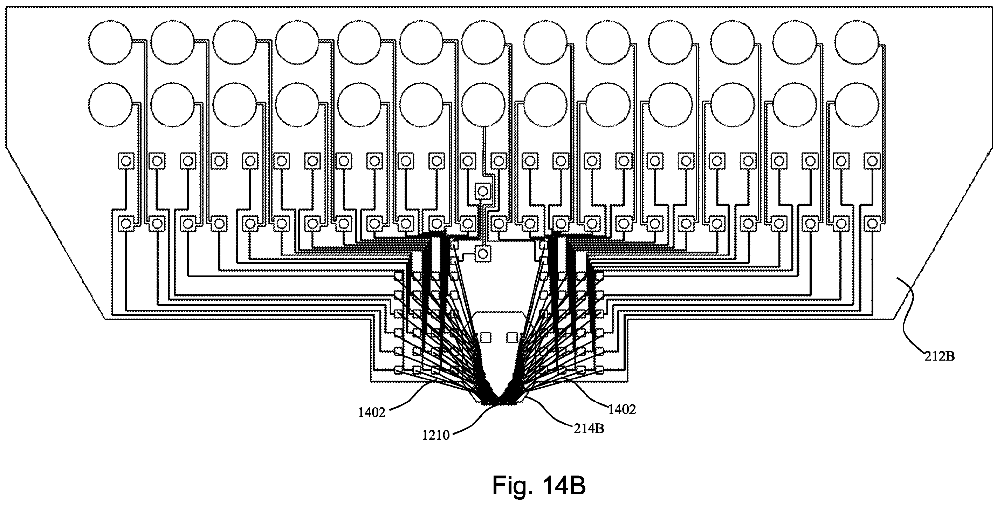

FIG. 14B, in accordance with an example embodiment, illustrates a probe chip 214B integrated with a probe board 212B. Wire bonds 1402 connect pads 1206 (see FIG. 12B) on the probe chip 214B to pads 1308 (see FIG. 13D) on the probe board 212B (see FIG. 13A). In another embodiment, the probe board 212B and probe chip 214B could be monolithically integrated on a single substrate. The single substrate could be silicon, silicon-germanium, PCB, Pyrex, glass, silica, ceramic, etc.

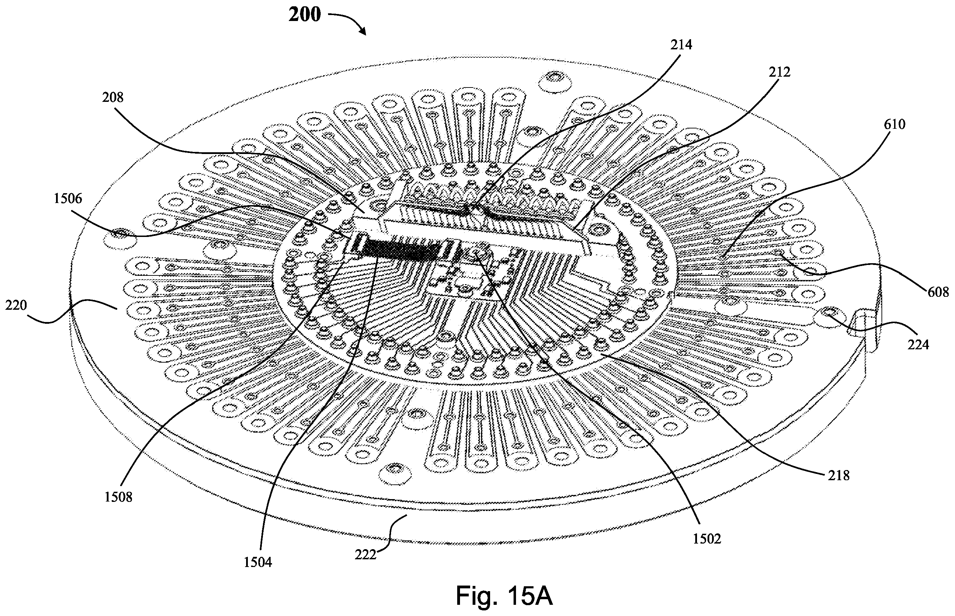

FIG. 15A, in accordance with an example embodiment, illustrates a probe card 200 comprising of a motherboard 220, daughterboard 218, and integrated camera 1502. A camera 1502 is integrated into the daughterboard 218. The camera is connected to the daughterboard 218 via cable 1504 and connector 1506. External signals are sent through the force via/pad 608, sense via/pad 610, along metal traces 1508 to operate the camera 1502. The use of the camera 1502 is threefold. First, the camera 1502 provides real-time monitoring of the shape and condition of the probe tips 1210 (see FIG. 14A) during probing of a wafer or sample. Any damage or debris that accumulate on the probe tips are reported by the camera to a computer system. The computer system runs a software program that utilizes pattern recognition, machine learning algorithms, and/or artificial intelligence (AI) to monitor probe tip shape and condition. A debris on the probe tip would change the shape of the probe tip. By using the software to monitor any debris on the probe tip, a well-timed probe tip cleaning process could be initiated either manually or automatically. Cleaning of the probe tips could be achieved by rubbing the probe tips in a polymer, gel, or fine sandpaper. The probe tips could also be immersed in an ultrasonic bath filled with liquid to remove the debris. Second, as the probe tip sustains wear and tear from numerous touchdowns, the software could alert an operator when the shape of the probe tip deviates substantially from that of a fresh probe tip. The software program can manually or automatically instruct the replacement of probe board 212, 212B and probe chip 214, 214B should the shape of the probe tip change. Third, during probing of a wafer or sample, the camera 1502 provides a real time image or video of the sample or wafer surface. The camera 1502 monitors probe tip alignment and overdrive marks on the wafer. Through software assisted routines such as image recognition, key features on the wafer could be identified and translated below the probe tips 1210. If there is any undesirable offset between the probe tips and features on the wafer, the software self corrects the misalignment through a feedback mechanism. The feedback mechanism is implemented through software where the apex of at least a probe tip 1210 and a region of interest on the wafer are identified. As an example, the center of the region of interest could be used. The images of the probe tip and region of interest are shown on a monitor and the software calculates the distance between the probe tip apex and the center of the region of interest. If the wafer is placed on a positioner with the probe card 200 above the wafer with tips in close contact with the wafer surface, then the software would instruct the positioner to move the wafer so that the center of the region of interest is below the probe tip. However, if the probe card 200 is mounted on a positioner above the wafer, then the software would instruct the positioner to move such that the probe tip is placed above the center of the region of interest. It should be noted that the camera 1502 could be affixed to translation stages and the translation stages could be connected to the daughterboard 218, 218B. The translation stages would ensure that the camera is in-focus and viewing the probe tips.

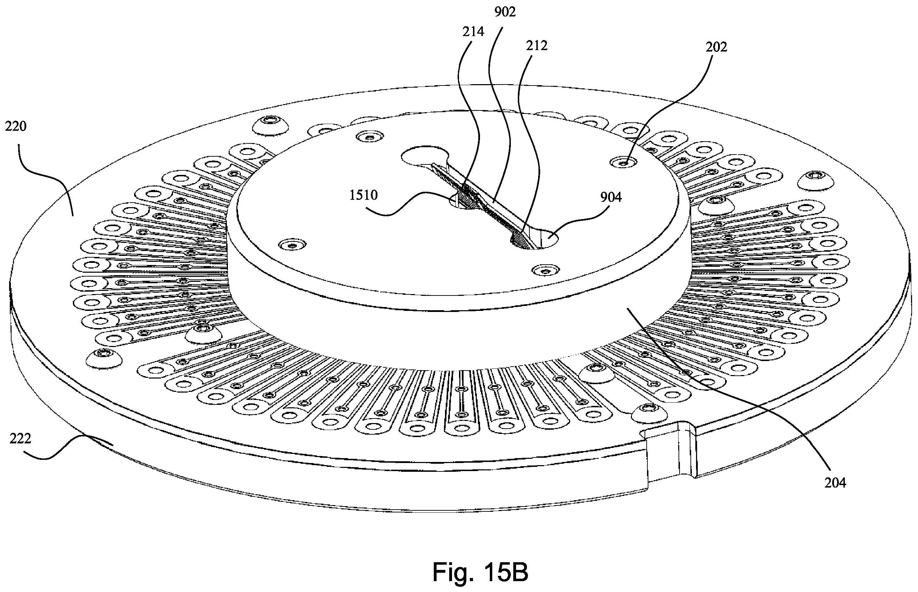

FIG. 15B, in accordance with an example embodiment, illustrates a probe card comprising of a motherboard 220 and a daughterboard 218 (not shown). A camera 1502 (not shown) is integrated to the daughterboard 218. The daughterboard cover 204 is integrated to protect or conceal the daughterboard 218. An opening 1510 is implemented in the daughterboard cover 204 to allow the camera 1502 to view the probe tips 1210 and sample or wafer under test.

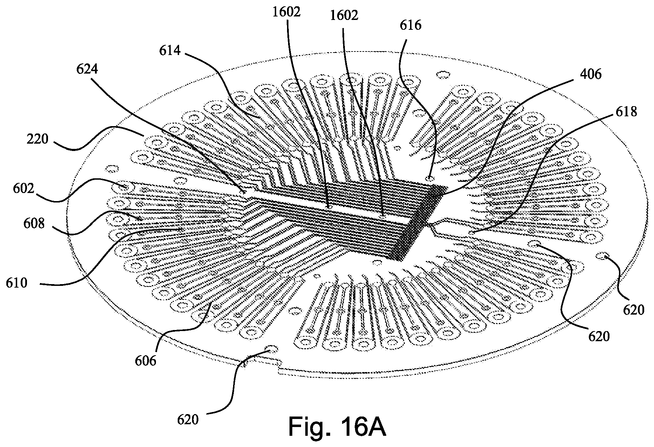

FIG. 16A, in accordance with an example embodiment, illustrates the frontside of a motherboard 220 designed with a G-F-S configuration. The motherboard 220 could be a PCB. The motherboard 220 could be made of FR4, ceramic, plastic, mica, Roger-board, etc. Metal plated vias (or pads) 602 connect to guard traces 606. Metal plated via (or pad) 608 is configured to provide a force signal from an ATE. Metal plated via (or pad) 610 is configured to receive a sense signal from an ATE. A metal trace 614 connects the force via/pad 608 to the sense via/pad 610 and pads 406 (see FIG. 4A). Screw 206B connects the motherboard 220 via hole 624 to the stiffener 222. The camera 1502 (see FIG. 15A) is connected to the motherboard 220 via screw holes 1602. Holes 618 accepts screws 202 (see FIG. 15B) from the daughterboard cover 204 (see FIG. 15B).

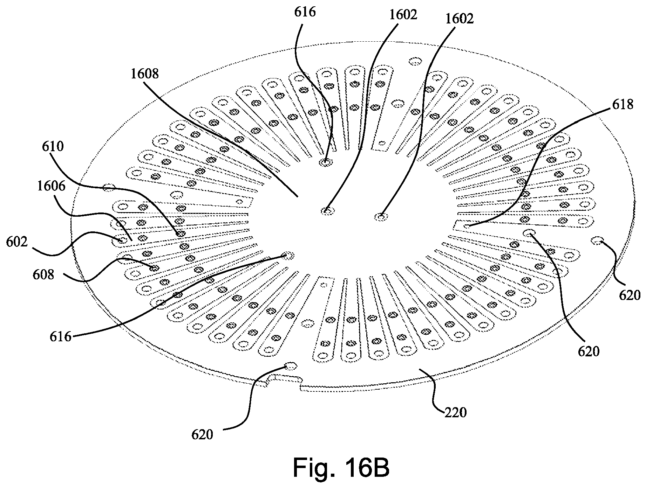

FIG. 16B, in accordance with an example embodiment, illustrates the backside of the motherboard 220. The motherboard 220 could be a PCB. A ground plane 1608 is implemented to minimize top metal trace 614 capacitive and resistive parasitics. The guard via 602 is connected to the backside ground plane 1606. The holes (or vias) 608, 610, 616, 1602 are electrically isolated from the ground plane 1606 and 1608.

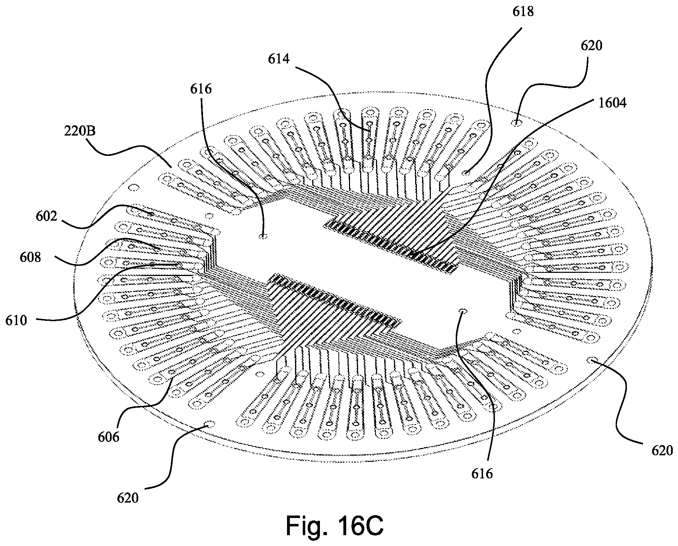

FIG. 16C, in accordance with an example embodiment, illustrates the frontside of a motherboard 220B designed with a G-F-S configuration. The motherboard 220B could be a PCB. The motherboard 220B could be made of FR4, ceramic, plastic, mica, Roger-board, etc. Metal plated vias (or pads) 602 connect to the guard traces 606. Metal plated via (or pad) 608 is configured to receive the force signal from an ATE. Metal plated via (or pad) 610 is configured to receive the sense signal from an ATE. A metal trace 614 connects the force via/pad 608 to the sense via/pad 610 to pads 1604. Screw 206A connects the probe head 208B to the motherboard 220B via hole 616. Holes 618 accepts screws 202 (see FIG. 15B) from the daughterboard cover 204 (see FIG. 15B).

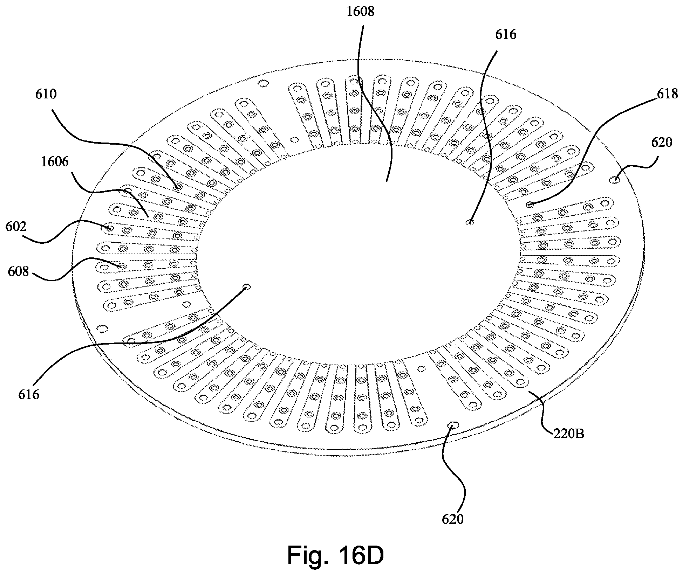

Referring to FIG. 16D, in accordance with an embodiment, is the backside of the motherboard 220B. The motherboard 220B could be a PCB. A ground plane 1608 is implemented to minimize top metal trace 614 capacitive and resistive parasitics. The guard via 602 is connected to the backside ground plane 1606. The holes (or vias) 608, 610, 616, 1602 are electrically isolated from the ground plane 1606 and 1608.

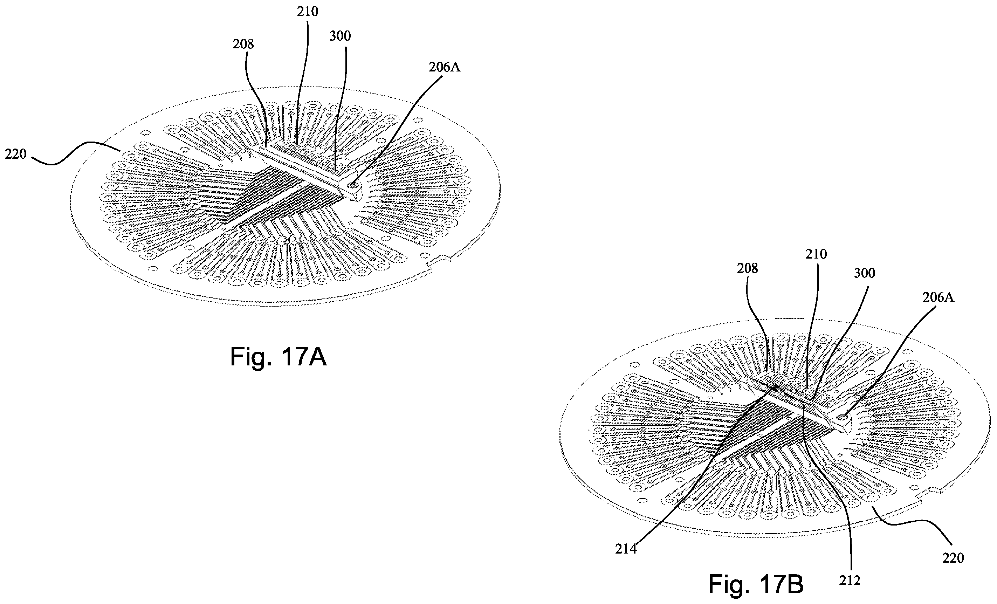

FIG. 17A, in accordance with an example embodiment, illustrates the frontside of motherboard 220. A probe head 208 is connected to the motherboard 220 via screws 206A. Pogo pins 300 are soldered to pads 406 (see FIG. 4A) on the motherboard 220.

FIG. 17B, in accordance with an example embodiment, illustrates the frontside of motherboard 220. A probe head 208 is connected to the motherboard 220 via screws 206A. Pogo pins 300 are soldered to pads 406 (see FIG. 4A) on the motherboard 220. A probe board 212 that houses a probe chip 214 is inserted into the probe head 208.

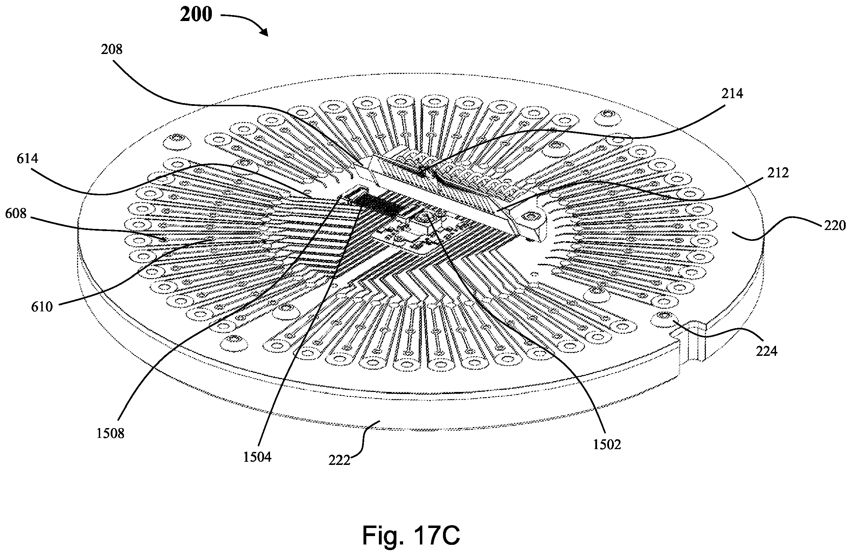

FIG. 17C, in accordance with an example embodiment, illustrates a probe card 200 comprising a motherboard 220 and an integrated camera 1502. The camera 1502 is connected to the motherboard via cable 1504 and connector 1508. External signals are sent through the force via/pad 608 or sense via/pad 610, along metal traces 614 to operate the camera 1502.

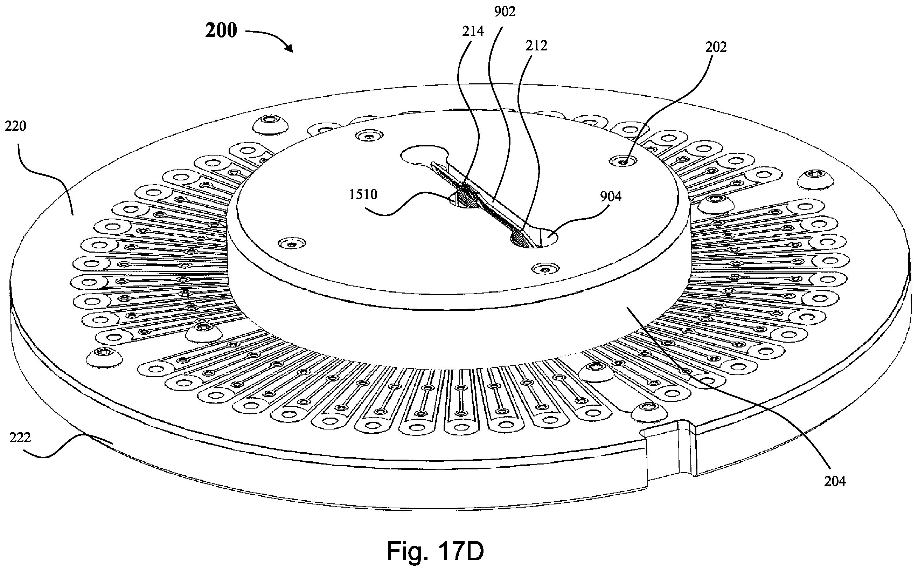

FIG. 17D, in accordance with an example embodiment, illustrates a probe card 200 with a daughterboard cover 204. An opening 1510 is implemented in the daughterboard cover 204 to allow the camera 1502 (see FIG. 17C) to view the probe tips 1210 and sample or wafer under test.

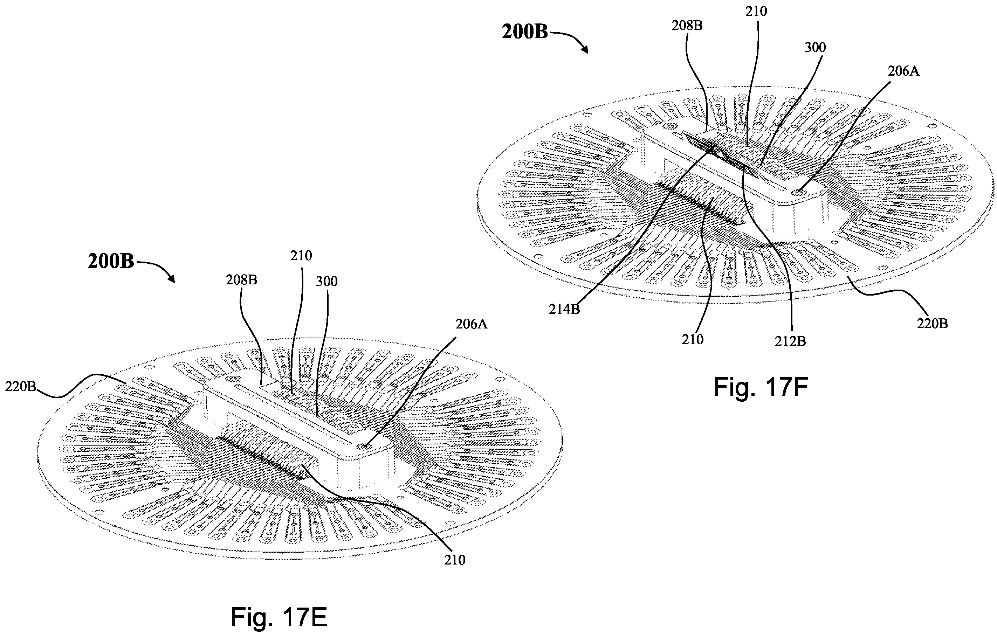

FIG. 17E, in accordance with an example embodiment, illustrates the frontside of motherboard 220B. A probe head 208B is connected to the motherboard 220B via screws 206A. Pogo pins 300 are soldered to pads 1604 (see FIG. 16C) on the motherboard 220B.

FIG. 17F, in accordance with an example embodiment, illustrates the frontside of motherboard 220B. A probe head 208B is connected to the motherboard 220B via screws 206A. Pogo pins 300 are soldered to pads 1604 on the motherboard 220B. A probe board 212B that houses a probe chip 214B is inserted into the probe head 208B. In another example embodiment, probe card 200B comprises a motherboard 220B and an integrated camera 1502 (see FIG. 17C). The camera is connected to the motherboard via cable 1504 and connector 1508 (see FIG. 17C). External signals are sent through the force via/pad 608 or sense via/pad 610, along metal traces 614 to operate the camera 1502.

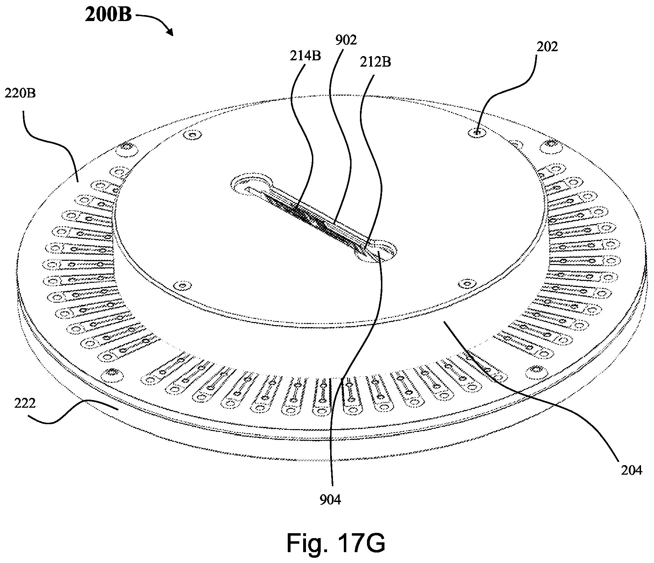

FIG. 17G, in accordance with an example embodiment, illustrates a probe card 200B that is integrated with a daughterboard cover 204 and a stiffener 222. A probe board 212B that houses a probe chip 214B is inserted into the probe card 200B.

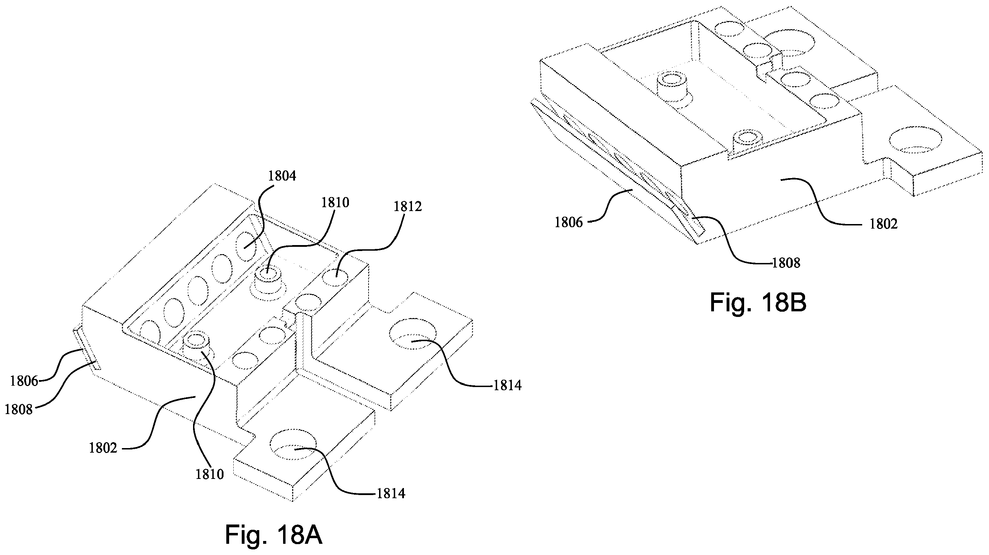

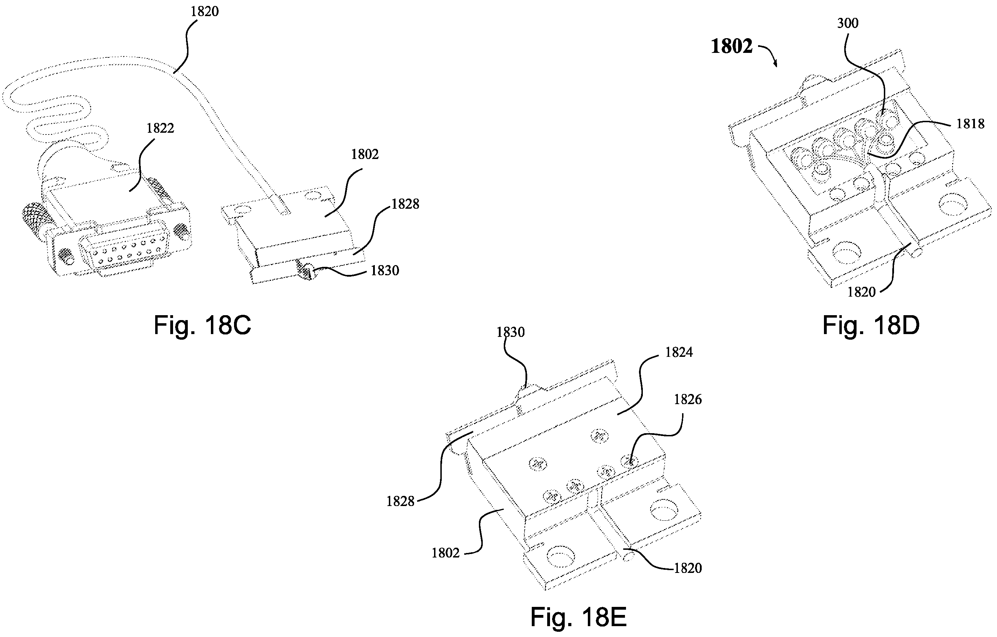

FIG. 18A, in accordance with an example embodiment, illustrates the backside of a probe head 1802. The probe head 1802 has an array of holes 1804 designed to accept pogo pins 300 (see FIG. 3D). The probe head 1802 has a front lid 1806 and a slot 1808. The slot 1808 is designed to accept a probe board 1828 (see FIG. 18C). Screw holes 1810 and 1812 are manufactured into the probe head 1802 and a backside cover 1824 (see FIG. 18E). Holes 1814 allow for the attachment of the probe head 1802 to a manipulator or post by inserting screws through holes 1814.

FIG. 18B, in accordance with an example embodiment, illustrates the side of a probe head 1802 having a slot 1808 and front lid 1806.

FIG. 18C, in accordance with an example embodiment, illustrates a probe head 1802. Wires inside cable 1820 are connected to cable connector 1822 and pogo pins 300 (see FIG. 3D) which are located inside the probe head 1802. A probe board 1828 that houses a probe chip 1830 is inserted into the probe head 1802.

FIG. 18D, in accordance with an example embodiment, illustrates a probe head 1802. Pogo pins 300 are inserted into holes 1804 (see FIG. 18A). The base 304 (see FIG. 3D) of the pogo pin 300 is soldered to a wire 1818. Multiple wires 1818 are bundled into a cable 1820 which are connected to a cable connector 1822 (see FIG. 18C).

FIG. 18E, in accordance with an example embodiment, illustrates a probe head 1802 with a backside cover 1824. The backside cover 1824 is secured to the probe head 1802 with screws 1826. A probe board 1828 that houses a probe chip 1830 is inserted into the probe head 1802.

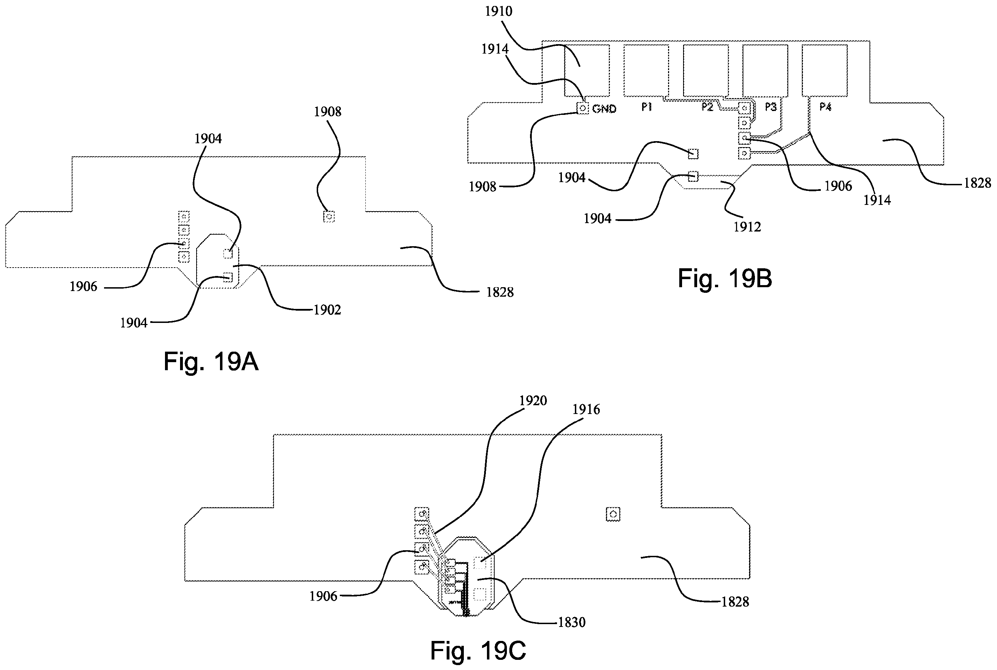

FIG. 19A, in accordance with an example embodiment, illustrates the frontside of a probe board 1828. The probe board 1828 could be a PCB. The probe board 1828 has a ground plane 1902 which the probe chip 1830 (see FIG. 19C) would sit on. The probe board 1828 further incudes metal plated vias 1906, 1908 and alignment holes (or pads or pillars) 1904.

FIG. 19B, in accordance with an example embodiment, illustrates the backside of a probe board 1828. The probe board 1828 has metal traces 1914 that connect vias 1906 to metal pads 1910. When the probe board 1828 is inserted into a probe head 1802 (see FIG. 18A), the metal pads 1910 make contact with the ball 310 (see FIG. 3D) of the pogo pin 300 (see FIG. 18D). The edge 1912 of the probe board 1828 is tapered at an angle to prevent the probe board 1828 from touching a sample surface or wafer during probing.

FIG. 19C, in accordance with an example embodiment, illustrates the frontside of a probe board 1828 that is connected to a probe chip 1830 using wire bonds 1920. The probe chip 1830 has the same design and material properties as probe chip 214 of FIG. 12A and 12B. The alignment holes 1916 on the probe chip 1830 are aligned to holes/pillars/pads 1904 (see FIGS. 19A and 19B) on the probe board 1828.

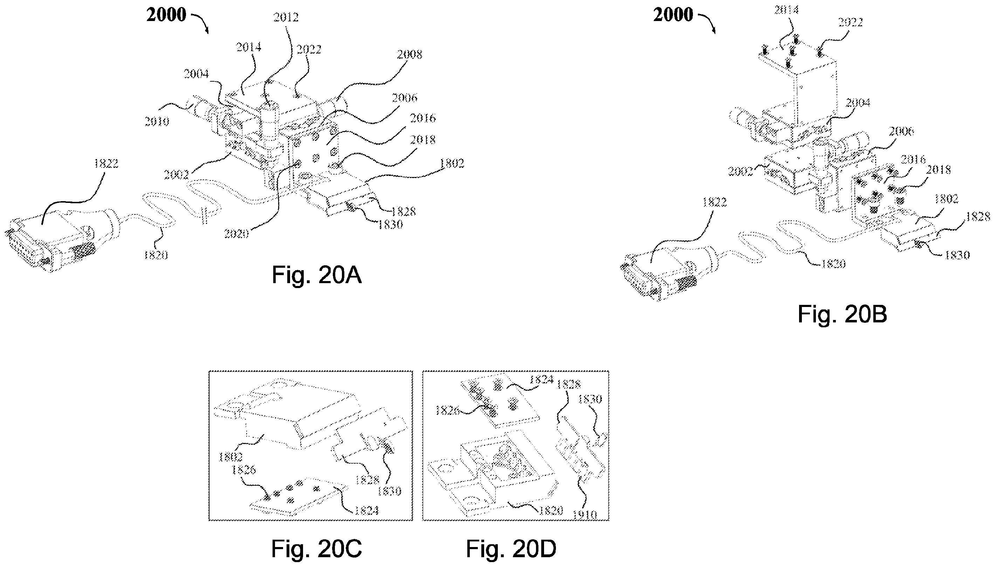

FIG. 20A, in accordance with an example embodiment, illustrates that the probe head 1802 is connected to an XYZ manipulator 2000. The manipulator is comprised of x-stage 2002, y-stage 2004, z-stage 2006 along with micro-screws 2008, 2010, and 2012. The z-stage 2006 is connected to an L-bracket 2014 and the L-bracket 2014 is secured to the y-stage with screws 2022. The stages could be manual or motorized or a combination thereof. The probe head 1802 is also connected to another L-bracket 2016 with screws 2018. The L-bracket 2016 is secured to the z-stage 2006 with screws 2020. A probe board 1828 that houses a probe chip 1830 is inserted into the probe head 1802. Wires in the cable 1820 are soldered to the pogo pins 300 (see FIG. 18D) located inside the probe head 1802. The other end of the cable 1820 is connected to a cable connector 1822.

FIG. 20B, in accordance with an example embodiment, illustrates an expanded view of the XYZ manipulator 2000 showing the various components.

FIG. 20C, in accordance with an example embodiment, illustrates an expanded view of the probe head assembly 1802 of FIG. 18E showing the various components.

FIG. 20D, in accordance with an example embodiment, illustrates an expanded view of the probe head assembly 1802 of FIG. 18E showing the various components. The probe board 1828 is inserted in such a way that the metal pads 1910 make physical contact with the balls 310 (see FIG. 3D) of the pogo pins 300 (see FIG. 18D).

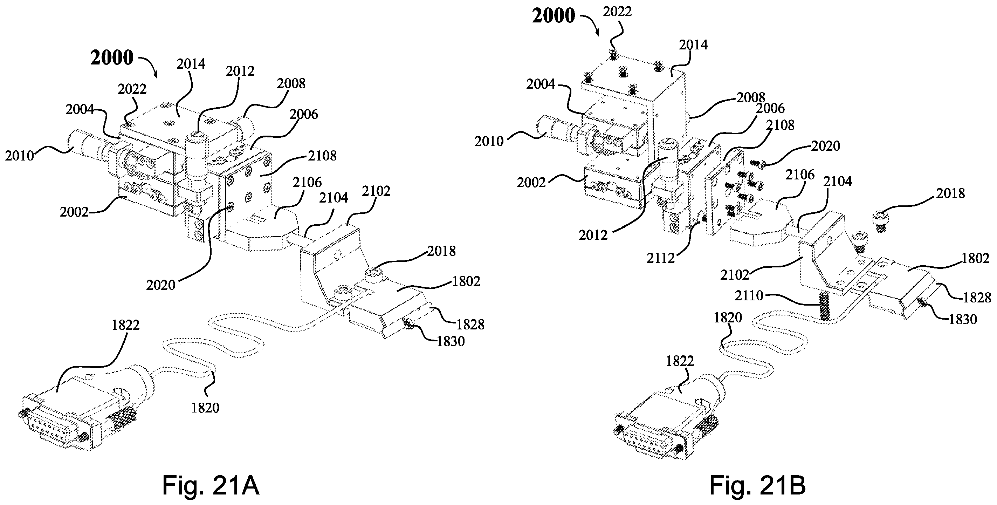

FIG. 21A, in accordance with an example embodiment, illustrates that the probe head 1802 is connected to an XYZ manipulator 2000. The XYZ manipulator 2000 is comprised of x-stage 2002, y-stage 2004, z-stage 2006 along with micro-screws 2008, 2010, and 2012. The z-stage 2006 is connected to an L-bracket 2014. The L-bracket 2014 is secured to the y-stage 2004 with screws 2022. The stages could be manual or motorized or a combination thereof. The probe head 1802 is also connected to an adapter 2102 with screws 2018. The adapter 2102 is connected to another adapter 2106 with a rod 2104. The adapter 2106 is connected to a plate 2108. The plate 2108 is secured to the z-stage 2006 with screws 2020. A probe board 1828 that houses a probe chip 1830 is inserted into the probe head 1802. Wires in the cable 1820 are soldered to the pogo pins 300 (see FIG. 18D) located inside the probe head 1802. The other end of the cable 1820 is connected to a cable connector 1822.

FIG. 21B, in accordance with an example embodiment, illustrates an expanded view of XYZ manipulator 2000, adapter 2102, and the probe head assembly 1802 showing the various components. A threaded rod or a spring plunger 2110 is used to limit the motion of the rod 2104. Screw 2112 secures adapter 2106 to plate 2108.

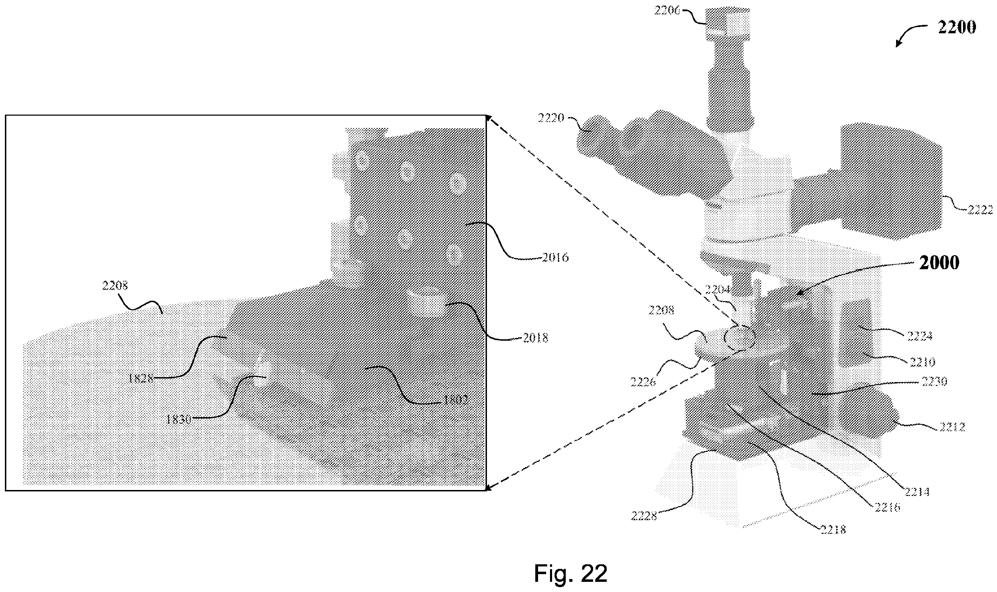

FIG. 22, in accordance with an example embodiment, illustrates a microscope 2200 that is integrated with the probe head 1802 and manipulator assembly 2000 of FIG. 20A. A sample or wafer 2208 is placed below the probe chip 1830 and the probe tips 1210 (as seen in FIG. 12A) could make a contact with the wafer 2208 without the probe board 1828 making a contact with the wafer 2208. The microscope 2200 has an objective 2204 to simultaneously view the probe tip 1210 and a region of interest on the wafer 2208. A camera 2206 is connected to the microscope 2200 to transmit images or video to a computer. The probe tip 1210 and wafer 2208 could also be viewed through the eyepiece 2220. The light source 2222 is powered-on with switch 2224 and its intensity is regulated with knob 2210. The wafer 2208 is secured on a chuck 2226 via vacuum suction. The chuck 2226 could be externally biased with a signal to apply a backside bias to the wafer 2208. The chuck 2226 is screwed into an XYZ positioner stage 2214. The positioner stage 2214 could be piezo electric and further connected to a rotating stage 2216. And lastly, the rotating stage 2216 is connected to an integrated XY stage 2218. The integrated XY stage 2218 is screwed into a baseplate 2228 and the baseplate 2228 is connected to a z-stage 2230 whose movement is controlled by the knob 2212.

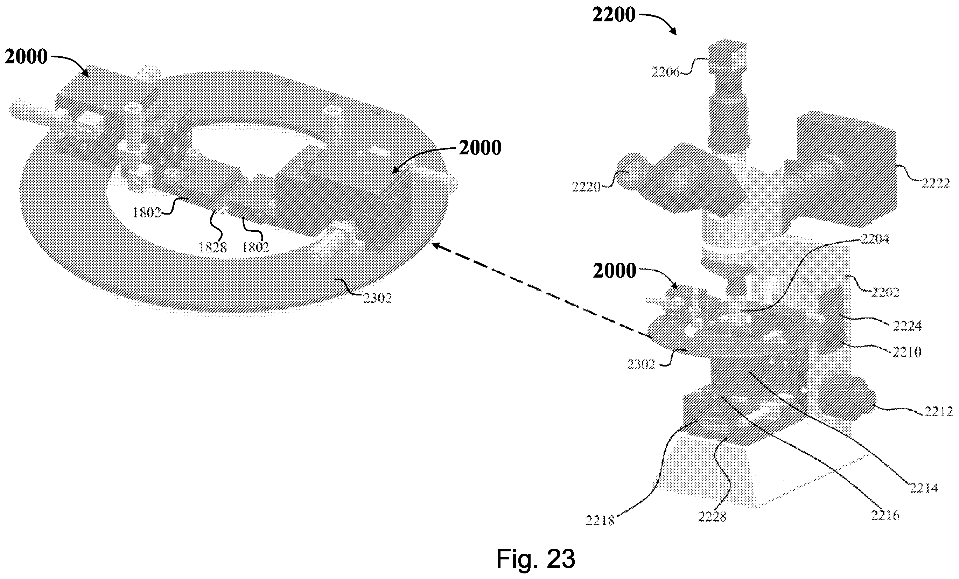

FIG. 23, in accordance with an example embodiment, illustrates that the microscope 2200 is adapted with a plate 2302. Manipulator assembly 2000 could be placed on the plate 2302. A probe board 1828 that house a probe chip 1830 is inserted into a probe head 1802 that is attached to the manipulator assembly 2000.

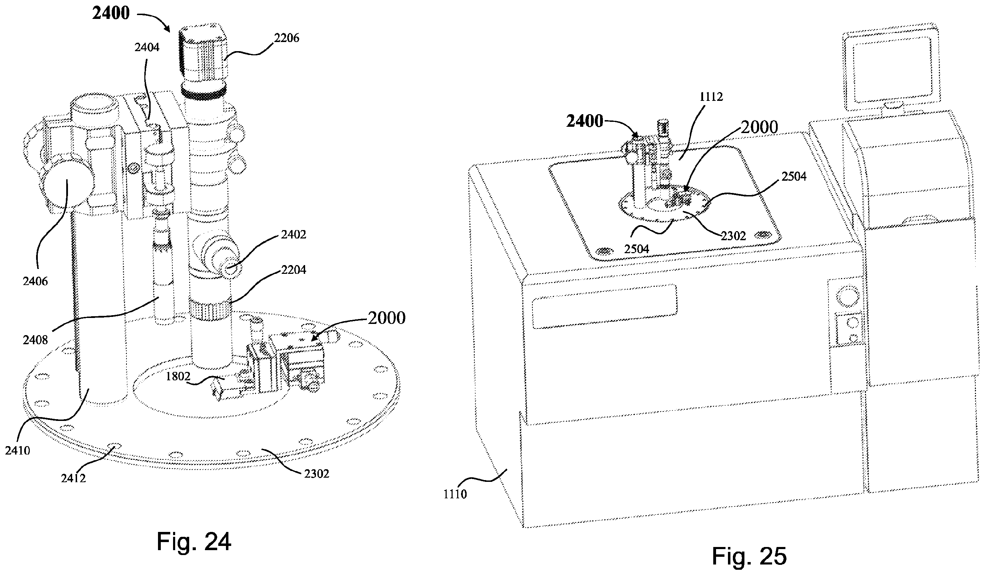

FIG. 24, in accordance with an example embodiment, illustrates that the microscope assembly 2400 comprises the manipulator assembly 2000 and microscope setup. Each manipulator assembly 2000 is comprised of probe head 1802, probe board 1828, probe chip 1830, and XYZ stages. The manipulator 2000 is affixed to the plate 2302. In addition, connected to the plate 2302 is the microscope setup which comprises an objective 2204, a light source 2402, a camera 2206, a Z-stage 2404 for ensuring that the probe tips and sample or wafer are in focus, and a micro-screw 2408 that adjusts the position of the Z-stage 2404 to bring the probe tips into focus. A knob 2406 helps with manual adjustment of the microscope setup, and the microscope setup is mounted on a rod 2410. Screw holes 2412 allow the microscope assembly 2400 to be mounted on wafer probers, microscopes, and positioners.

FIG. 25, in accordance with an example embodiment, illustrates that the microscope assembly 2400 is mounted on top of a wafer prober 1110. Screws 2504 are used to connect the plate 2302 of the microscope assembly 2400 to the top plate 1112 of the wafer prober. Inside the wafer prober is a positioner with at least one degree of freedom. Typically, the positioner could comprise of XYZ stages, rotational stage, and tilt stages. The wafer or sample under test is placed on the positioner and software scripts used to instruct the movement of the positioner.

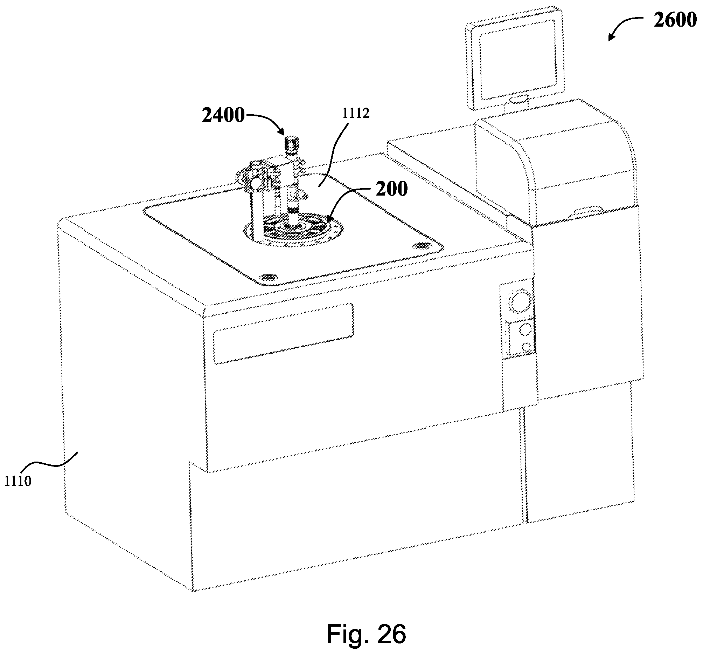

FIG. 26, in accordance with an example embodiment, illustrates that the probe card 200 (as shown in FIG. 11C) is mounted on top of a wafer prober 1110. Clamps (not shown) in the top cover 1112 of the wafer prober 1110 mechanically secure the probe card 200 to the prober. A microscope setup 2400 (without the manipulator) is mounted on the top cover 1112 of the wafer prober 1110. Note that in this setup, there is a hole in both the daughterboard 218 (see FIG. 10B) and motherboard 220 (see FIG. 10B) of probe card 200 to allow the microscope setup 2400 to view the probe tips 1210 and wafer surface. In another example embodiment, the microscope setup is screwed directly into the backside of the stiffener 222 (see FIG. 11C).

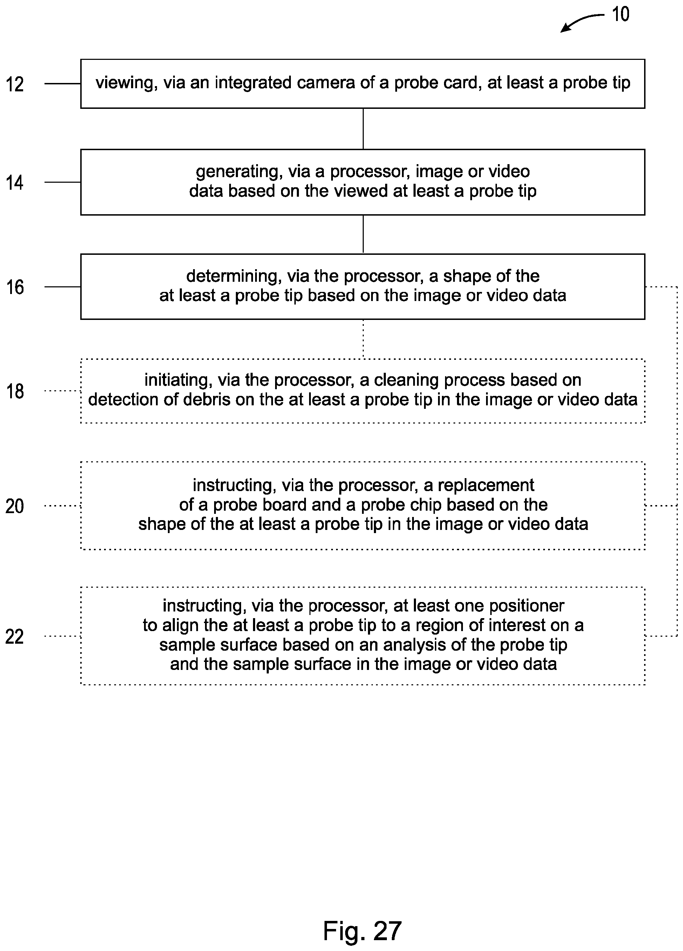

FIG. 27 is an unclaimed example method 10 of monitoring a condition of at least a probe tip.
The method 10 includes viewing 12, via an integrated camera of a probe card, the at least a probe tip. The method 10 further includes generating 14, via a processor, image or video data based on the viewed at least a probe tip. The processor may use a software program stored in a memory to generate the image or video data. The method 10 further includes determining 16, via the processor, a shape of the at least a probe tip based on the image or video data. The processor may use the software program stored in a memory to determine the shape of the at least a probe tip.

According to an example, the method 10 may further include the optional step of initiating 18, via the processor, a cleaning process based on detection of debris on the at least a probe tip in the image or video data. The cleaning process may be initiated by the software program stored in the memory. The cleaning process may be initiated manually or automatically.

According to another example, the method 10 further includes instructing 20, via the processor, a replacement of a probe board and a probe chip based on the shape of the probe tip in the image or video data. The instruction may be provided by the software program. The instructions may be issued manually or automatically.

According to a further example, the method 10 further includes instructing 22, via the processor, at least one positioner to align the at least a probe tip to a region of interest on a sample surface based on an analysis of the at least a probe tip and the sample surface in the image or video data. The analysis and/or instruction may be provided by the software program.

All definitions, as defined and used herein, should be understood to control over dictionary definitions, definitions in documents incorporated by reference, and/or ordinary meanings of the defined terms.

The indefinite articles "a" and "an," as used herein in the specification and in the claims, unless clearly indicated to the contrary, should be understood to mean "at least one."

The phrase "and/or," as used herein in the specification and in the claims, should be understood to mean "either or both" of the elements so conjoined, i.e., elements that are conjunctively present in some cases and disjunctively present in other cases. Multiple elements listed with "and/or" should be construed in the same fashion, i.e., "one or more" of the elements so conjoined. Other elements can optionally be present other than the elements specifically identified by the "and/or" clause, whether related or unrelated to those elements specifically identified.

As used herein in the specification and in the claims, "or" should be understood to have the same meaning as "and/or" as defined above. For example, when separating items in a list, "or" or "and/or" shall be interpreted as being inclusive, i.e., the inclusion of at least one, but also including more than one, of a number or list of elements, and, optionally, additional unlisted items. Only terms clearly indicated to the contrary, such as "only one of" or "exactly one of," or, when used in the claims, "consisting of," will refer to the inclusion of exactly one element of a number or list of elements. In general, the term "or" as used herein shall only be interpreted as indicating exclusive alternatives (i.e., "one or the other but not both") when preceded by terms of exclusivity, such as "either," "one of," "only one of," or "exactly one of."

As used herein in the specification and in the claims, the phrase "at least one," in reference to a list of one or more elements, should be understood to mean at least one element selected from any one or more of the elements in the list of elements, but not necessarily including at least one of each and every element specifically listed within the list of elements and not excluding any combinations of elements in the list of elements. This definition also allows that elements can optionally be present other than the elements specifically identified within the list of elements to which the phrase "at least one" refers, whether related or unrelated to those elements specifically identified.

It should also be understood that, unless clearly indicated to the contrary, in any methods claimed herein that include more than one step or act, the order of the steps or acts of the method is not necessarily limited to the order in which the steps or acts of the method are recited.

In the claims, as well as in the specification above, all transitional phrases such as "comprising," "including," "carrying," "having," "containing," "involving," "holding," "composed of," and the like are to be understood to be open-ended, i.e., to mean including but not limited to. Only the transitional phrases "consisting of" and "consisting essentially of" shall be closed or semi-closed transitional phrases, respectively.

The above-described examples of the described subject matter can be implemented in any of numerous ways. For example, some aspects can be implemented using hardware, software, or a combination thereof. When any aspect is implemented at least in part in software, the software code can be executed on any suitable processor or collection of processors, whether provided in a single device or computer or distributed among multiple devices/computers.

The present disclosure can be implemented as a system, a method, and/or a computer program product at any possible technical detail level of integration. The computer program product can include a computer readable storage medium (or media) having computer readable program instructions thereon for causing a processor to carry out aspects of the present disclosure.

The computer readable storage medium can be a tangible device that can retain and store instructions for use by an instruction execution device. The computer readable storage medium can be, for example, but is not limited to, an electronic storage device, a magnetic storage device, an optical storage device, an electromagnetic storage device, a semiconductor storage device, or any suitable combination of the foregoing. A non-exhaustive list of more specific examples of the computer readable storage medium includes the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon, and any suitable combination of the foregoing. A computer readable storage medium, as used herein, is not to be construed as being transitory signals per se, such as radio waves or other freely propagating electromagnetic waves, electromagnetic waves propagating through a waveguide or other transmission media (e.g., light pulses passing through a fiber-optic cable), or electrical signals transmitted through a wire.

Computer readable program instructions described herein can be downloaded to respective computing/processing devices from a computer readable storage medium or to an external computer or external storage device via a network, for example, the Internet, a local area network, a wide area network and/or a wireless network. The network can comprise copper transmission cables, optical transmission fibers, wireless transmission, routers, firewalls, switches, gateway computers and/or edge servers. A network adapter card or network interface in each computing/processing device receives computer readable program instructions from the network and forwards the computer readable program instructions for storage in a computer readable storage medium within the respective computing/processing device.

Computer readable program instructions for carrying out operations of the present disclosure can be assembler instructions, instruction-set-architecture (ISA) instructions, machine instructions, machine dependent instructions, microcode, firmware instructions, state-setting data, configuration data for integrated circuitry, or either source code or object code written in any combination of one or more programming languages, including an object oriented programming language such as Smalltalk, C++, or the like, and procedural programming languages, such as the "C" programming language or similar programming languages. The computer readable program instructions can execute entirely on the user's computer, partly on the user's computer, as a stand-alone software package, partly on the user's computer and partly on a remote computer or entirely on the remote computer or server. In the latter scenario, the remote computer can be connected to the user's computer through any type of network, including a local area network (LAN) or a wide area network (WAN), or the connection can be made to an external computer (for example, through the Internet using an Internet Service Provider). In some examples, electronic circuitry including, for example, programmable logic circuitry, field-programmable gate arrays (FPGA), or programmable logic arrays (PLA) can execute the computer readable program instructions by utilizing state information of the computer readable program instructions to personalize the electronic circuitry, in order to perform aspects of the present disclosure.

Aspects of the present disclosure are described herein with reference to flowchart illustrations and/or block diagrams of methods, apparatus (systems), and computer program products according to examples of the disclosure. It will be understood that each block of the flowchart illustrations and/or block diagrams, and combinations of blocks in the flowchart illustrations and/or block diagrams, can be implemented by computer readable program instructions.

The computer readable program instructions can be provided to a processor of a, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks. These computer readable program instructions can also be stored in a computer readable storage medium that can direct a computer, a programmable data processing apparatus, and/or other devices to function in a particular manner, such that the computer readable storage medium having instructions stored therein comprises an article of manufacture including instructions which implement aspects of the function/act specified in the flowchart and/or block diagram or blocks.

The computer readable program instructions can also be loaded onto a computer, other programmable data processing apparatus, or other device to cause a series of operational steps to be performed on the computer, other programmable apparatus, or other device to produce a computer implemented process, such that the instructions which execute on the computer, other programmable apparatus, or other device implement the functions/acts specified in the flowchart and/or block diagram block or blocks.

The flowchart and block diagrams in the Figures illustrate the architecture, functionality, and operation of possible implementations of systems, methods, and computer program products according to various examples of the present disclosure. In this regard, each block in the flowchart or block diagrams can represent a module, segment, or portion of instructions, which comprises one or more executable instructions for implementing the specified logical function(s). In some alternative implementations, the functions noted in the blocks can occur out of the order noted in the Figures. For example, two blocks shown in succession can, in fact, be executed substantially concurrently, or the blocks can sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts or carry out combinations of special purpose hardware and computer instructions.

Other implementations are within the scope of the following claims and other claims to which the applicant can be entitled.

While various examples have been described and illustrated herein, those of ordinary skill in the art will readily envision a variety of other means and/or structures for performing the function and/or obtaining the results and/or one or more of the advantages described herein, and each of such variations and/or modifications is deemed to be within the scope of the examples described herein. More generally, those skilled in the art will readily appreciate that all parameters, dimensions, materials, and configurations described herein are meant to be exemplary and that the actual parameters, dimensions, materials, and/or configurations will depend upon the specific application or applications for which the teachings is/are used. Those skilled in the art will recognize, or be able to ascertain using no more than routine experimentation, many equivalents to the specific examples described herein. Examples of the present disclosure are directed to each individual feature, system, article, material, kit, and/or method described herein. In addition, any combination of two or more such features, systems, articles, materials, kits, and/or methods, if such features, systems, articles, materials, kits, and/or methods are not mutually inconsistent, is included within the scope of the present disclosure.

## Claims

1. A probe head (208, 208B, 1802), the probe head comprising:
at least a pogo pin (300);
a slot (306, 1808) for inserting a probe board (212, 212B, 1828);
and a front lid (308, 1806),
wherein the pogo pin (300) has a rotating ball (310) at its apex, wherein the rotating ball (310) is spring-loaded and translates up and down along a shank of the pogo pin (300), and wherein the rotating ball (310) is configured to make physical contact with a metal pad or via on the probe board (212, 212B, 1828).

2. The probe head (208, 208B, 1802) of claim 1, wherein a probe board that houses a probe chip is inserted into the slot (306,1808).

3. A probe card comprising:
the probe head (208, 208B) of claim 1 or claim 2;
a daughterboard (218, 218B);
a motherboard (220, 220B); and
a wire
wherein the probe head is connected to the daughterboard (218, 218B), wherein the daughterboard (218, 218B) is a printed circuit board, wherein a first end of the wire is soldered to the pogo pin (300) and a second end is soldered to a metal pad on the daughterboard (218, 218B), and wherein the daughterboard (218, 218B) is connected to the motherboard (220, 220B).

4. The probe card of claim 3, wherein the daughterboard (218, 218B) is connected to the motherboard (220, 220B) by using metal pins or pogo pins.

5. The probe card of claim 4, wherein the motherboard (220, 220B) is connected to a stiffener, wherein the motherboard (220, 220B) is a printed circuit board, and wherein the metal pins are designed to press-fit into the motherboard (220, 220B) or the daughterboard (218, 218B).

6. The probe card of claim 3 further comprising a daughterboard cover, wherein the daughterboard (218, 218B) is covered with the daughterboard cover, wherein the daughterboard cover has a slot to allow for a probe board to be inserted into the probe head.

7. A probe card comprising:
the probe head (208, 208B) of claim 1 or claim 2;
a motherboard (220, 220B); and
a wire;
wherein the probe head is connected to the motherboard (220, 220B), wherein a first end of the wire is soldered to the pogo pin (300) and a second end is soldered to a metal pad on the motherboard (220, 220B).

8. The probe card of claim 7, wherein the motherboard is connectable to a stiffener.

9. The probe card of claim 7, further comprising a daughterboard cover, wherein the motherboard (220, 220B) is covered with the daughterboard cover, and wherein the daughterboard cover has a slot to allow for a probe board to be inserted into the probe head.

10. The probe card of claim 6 or claim 9, wherein the daughterboard cover has a first opening for inserting at least a finger, a tweezer, or a clamp, and wherein the daughterboard cover has a second opening for a camera that tracks a position and a status of at least one probe.

11. The probe card of claim 3 or claim 7, further comprising a camera, wherein the camera is connected to the daughterboard when dependent on claim 3 and to the motherboard (220, 220B) when dependent on claim 7, to view at least one probe tip.

12. A system comprising:
the probe head of claims 1 or 2; and
a manipulator, wherein the probe head is connected to the manipulator.

13. The system of claim 12, further comprising:
a microscope;
a plate; and
a microscope setup;
wherein the manipulator is mounted onto the microscope, wherein the manipulator is connected to the plate, wherein the microscope setup is connected to the plate, wherein the plate is configured to be arranged above a positioner, and wherein the plate is connectable to a wafer prober.

14. The probe head of claim 1, wherein the probe head is connectable to a cable, wherein the cable is comprised of wires, and wherein a first end of a wire is soldered to the pogo pin located inside the probe head and a second end of the wire is connected to a cable connector.

15. The probe head of claim 1, wherein the pogo pin (300) is configured to be inserted into the front lid (308) and a backside (320) of the probe head.

## Patentansprüche

1. Sondenkopf (208, 208B, 1802), wobei der Sondenkopf Folgendes umfasst:
mindestens einen Pogo-Pin (300);
einen Schlitz (306, 1808) zum Einsetzen einer Sondenplatine (212, 212B, 1828);
und einen vorderen Deckel (308, 1806),
wobei der Pogo-Pin (300) an seiner Spitze eine rotierende Kugel (310) aufweist, wobei die rotierende Kugel (310) federbelastet ist und sich entlang eines Schafts des Pogo-Pins (300) auf und ab bewegt, und wobei die rotierende Kugel (310) dazu ausgelegt ist, physischen Kontakt mit einem Metall-Pad oder einer Via auf der Sondenplatine (212, 212B, 1828) herzustellen.

2. Sondenkopf (208, 208B, 1802) nach Anspruch 1, wobei eine Sondenplatine, die einen Sondenchip aufnimmt, in den Schlitz (306, 1808) eingesetzt ist.

3. Sondenkarte, umfassend:
den Sondenkopf (208, 208B) nach Anspruch 1 oder Anspruch 2;
eine Tochterplatine (218, 218B);
eine Hauptplatine (220, 220B); und
einen Draht,
wobei der Sondenkopf mit der Tochterplatine (218, 218B) verbunden ist, wobei die Tochterplatine (218, 218B) eine Leiterplatte ist, wobei ein erstes Ende des Drahtes an den Pogo-Pin (300) gelötet ist und ein zweites Ende an ein Metall-Pad auf der Tochterplatine (218, 218B) gelötet ist, und wobei die Tochterplatine (218, 218B) mit der Hauptplatine (220, 220B) verbunden ist.

4. Sondenkarte nach Anspruch 3, wobei die Tochterplatine (218, 218B) mittels Metallstiften oder Pogo-Pins mit der Hauptplatine (220, 220B) verbunden ist.

5. Sondenkarte nach Anspruch 4, wobei die Hauptplatine (220, 220B) mit einer Versteifung verbunden ist, wobei die Hauptplatine (220, 220B) eine Leiterplatte ist und wobei die Metallstifte dazu ausgelegt sind, in die Hauptplatine (220, 220B) oder die Tochterplatine (218, 218B) eingepresst zu werden.

6. Sondenkarte nach Anspruch 3, ferner umfassend eine Tochterplatinenabdeckung, wobei die Tochterplatine (218, 218B) mit der Tochterplatinenabdeckung abgedeckt ist und wobei die Tochterplatinenabdeckung einen Schlitz aufweist, um das Einsetzen einer Sondenplatine in den Sondenkopf zu ermöglichen.

7. Sondenkarte, umfassend:
den Sondenkopf (208, 208B) nach Anspruch 1 oder Anspruch 2;
eine Hauptplatine (220, 220B); und
einen Draht;
wobei der Sondenkopf mit der Hauptplatine (220, 220B) verbunden ist, wobei ein erstes Ende des Drahtes an den Pogo-Pin (300) gelötet ist und ein zweites Ende an ein Metall-Pad auf der Hauptplatine (220, 220B) gelötet ist.

8. Sondenkarte nach Anspruch 7, wobei die Hauptplatine mit einer Versteifung verbindbar ist.

9. Sondenkarte nach Anspruch 7, ferner umfassend eine Tochterplatinenabdeckung, wobei die Hauptplatine (220, 220B) mit der Tochterplatinenabdeckung abgedeckt ist und wobei die Tochterplatinenabdeckung einen Schlitz aufweist, um das Einsetzen einer Sondenplatine in den Sondenkopf zu ermöglichen.

10. Sondenkarte nach Anspruch 6 oder Anspruch 9, wobei die Tochterplatinenabdeckung eine erste Öffnung zum Einführen zumindest eines Fingers, einer Pinzette oder einer Klemme aufweist und wobei die Tochterplatinenabdeckung eine zweite Öffnung für eine Kamera aufweist, die eine Position und einen Status zumindest einer Sonde erfasst.

11. Sondenkarte nach Anspruch 3 oder Anspruch 7, ferner umfassend eine Kamera, wobei die Kamera mit der Tochterplatine verbunden ist, wenn sie von Anspruch 3 abhängt, und mit der Hauptplatine (220, 220B), wenn sie von Anspruch 7 abhängt, um mindestens eine Sondenspitze zu betrachten.

12. System, umfassend:
den Sondenkopf nach Anspruch 1 oder 2; und
einen Manipulator, wobei der Sondenkopf mit dem Manipulator verbunden ist.

13. System nach Anspruch 12, ferner umfassend:
ein Mikroskop;
eine Platte; und
eine Mikroskopanordnung;
wobei der Manipulator an dem Mikroskop montiert ist, wobei der Manipulator mit der Platte verbunden ist, wobei die Mikroskopanordnung mit der Platte verbunden ist, wobei die Platte dazu konfiguriert ist, über einem Positionierer angeordnet zu werden, und wobei die Platte mit einer Wafer-Sonde verbindbar ist.

14. Sondenkopf nach Anspruch 1, wobei der Sondenkopf mit einem Kabel verbindbar ist, wobei das Kabel aus Drähten besteht und wobei ein erstes Ende eines Drahtes an den im Inneren des Sondenkopfes befindlichen Pogo-Pin gelötet ist und ein zweites Ende des Drahtes mit einem Kabelstecker verbunden ist.

15. Sondenkopf nach Anspruch 1, wobei der Pogo-Pin (300) dazu ausgelegt ist, in den vorderen Deckel (308) und eine Rückseite (320) des Sondenkopfs eingesetzt zu werden.

## Revendications

1. Tête de sonde (208, 208B, 1802), la tête de sonde comprenant :
au moins une broche Pogo (300) ;
une fente (306, 1808) permettant d'insérer une carte de sonde (212, 212B, 1828) ;
et un couvercle avant (308, 1806),
dans laquelle la broche Pogo (300) a une bille rotative (310) au niveau de son sommet, dans laquelle la bille rotative (310) est montée sur ressort et effectue un mouvement de translation vers le haut et vers le bas le long d'une tige de la broche Pogo (300), et dans laquelle la bille rotative (310) est conçue pour entrer en contact physique avec une pastille métallique ou un trou d'interconnexion sur la carte de sonde (212, 212B, 1828) .

2. Tête de sonde (208, 208B, 1802) selon la revendication 1, dans laquelle une carte de sonde qui loge une puce de sonde est insérée dans la fente (306,1808).

3. Carte de sonde comprenant :
la tête de sonde (208, 208B) selon la revendication 1 ou la revendication 2 ;
une carte fille (218, 218B) ;
une carte mère (220, 220B) ; et
un fil
dans laquelle la tête de sonde est connectée à la carte fille (218, 218B), dans laquelle la carte fille (218, 218B) est une carte de circuit imprimé, dans laquelle une première extrémité du fil est soudée à la broche Pogo (300) et une seconde extrémité est soudée à une pastille métallique sur la carte fille (218, 218B) et dans laquelle la carte fille (218, 218B) est connectée à la carte mère (220, 220B).

4. Carte de sonde selon la revendication 3, dans laquelle la carte fille (218, 218B) est connectée à la carte mère (220, 220B) à l'aide de broches métalliques ou de broches Pogo.

5. Carte de sonde selon la revendication 4, dans laquelle la carte mère (220, 220B) est reliée à un raidisseur, dans laquelle la carte mère (220, 220B) est une carte de circuit imprimé, et dans laquelle les broches métalliques sont conçues pour s'emmancher à force dans la carte mère (220, 220B) ou la carte fille (218, 218B).

6. Carte de sonde selon la revendication 3 comprenant en outre un capot de carte fille, dans laquelle la carte fille (218, 218B) est recouverte par le capot de carte fille, dans laquelle le capot de carte fille a une fente pour permettre à une carte de sonde d'être insérée dans la tête de sonde.

7. Carte de sonde comprenant :
la tête de sonde (208, 208B) selon la revendication 1 ou la revendication 2 ;
une carte mère (220, 220B) ; et
un fil ;
dans laquelle la tête de sonde est connectée à la carte mère (220, 220B), dans laquelle une première extrémité du fil est soudée à la broche Pogo (300) et une seconde extrémité est soudée à une pastille métallique sur la carte mère (220, 220B).

8. Carte de sonde selon la revendication 7, dans laquelle la carte mère peut être reliée à un raidisseur.

9. Carte de sonde selon la revendication 7, comprenant en outre un capot de carte fille, dans laquelle la carte mère (220, 220B) est recouverte par le capot de carte fille, et dans laquelle le capot de carte fille a une fente pour permettre à une carte de sonde d'être insérée dans la tête de sonde.

10. Carte de sonde selon la revendication 6 ou la revendication 9, dans laquelle le capot de carte fille a une première ouverture permettant d'insérer au moins un doigt, une pince à épiler ou une pince, et dans laquelle le capot de carte fille a une seconde ouverture pour une caméra qui suit une position et un état d'au moins une sonde.

11. Carte de sonde selon la revendication 3 ou la revendication 7, comprenant en outre une caméra, dans laquelle la caméra est connectée à la carte fille lorsqu'elle dépend de la revendication 3 et à la carte mère (220, 220B) lorsqu'elle dépend de la revendication 7, pour visualiser au moins une pointe de sonde.

12. Système comprenant :
la tête de sonde selon les revendications 1 ou 2 ; et
un manipulateur, dans lequel la tête de sonde est reliée au manipulateur.

13. Système selon la revendication 12, comprenant en outre :
un microscope ;
une plaque ; et
un ensemble microscope ;
dans lequel le manipulateur est monté sur le microscope, dans lequel le manipulateur est relié à la plaque, dans lequel l'ensemble microscope est relié à la plaque, dans lequel la plaque est conçue pour être agencée au-dessus d'un positionneur, et dans lequel la plaque peut être reliée à une machine de test sous pointes.

14. Tête de sonde selon la revendication 1, dans laquelle la tête de sonde peut être connectée à un câble, dans laquelle le câble est constitué de fils, et dans laquelle une première extrémité d'un fil est soudée à la broche Pogo située à l'intérieur de la tête de sonde et une seconde extrémité du fil est connectée à un connecteur de câble.

15. Tête de sonde selon la revendication 1, dans laquelle la broche Pogo (300) est conçue pour être insérée dans le couvercle avant (308) et dans une face arrière (320) de la tête de sonde.
